# EUROPEAN PATENT APPLICATION

(11) **EP 4 343 858 A1**
(43) Date of publication of application: **27.03.2024**
(21) Application number: 22804489.7
(22) Date of filing: 19.04.2022
(51) Int. Cl.: H01L 31/0352, H01L 31/10, H01L 27/146, H01L 27/30

(54) **PHOTOELECTRIC CONVERSION ELEMENT AND IMAGING DEVICE**

(30) Priority: 21.05.2021 JP 2021086045
(71) Applicant: Panasonic Intellectual Property Management Co., Ltd., Kadoma-shi, Osaka 571-0057 (JP)
(72) Inventor: MACHIDA, Shinichi, Kadoma-shi Osaka 571-0057 (JP); MATSUKAWA, Nozomu, Kadoma-shi Osaka 571-0057 (JP); SANO, Fumiya, Kadoma-shi Osaka 571-0057 (JP)
(74) Representative: Grünecker Patent- und Rechtsanwälte PartG mbB
(86) International application number: PCT/JP2022/018142
(87) International publication number: WO 2022/244575

(57) **Abstract**

A photoelectric conversion element includes a photoelectric conversion layer, a first electrode that collects holes generated in the photoelectric conversion layer, and a second electrode that is positioned opposite to the first electrode with the photoelectric conversion layer being disposed between the second electrode and the first electrode and that collects electrons generated in the photoelectric conversion layer. The photoelectric conversion layer includes a first quantum dot layer including a plurality of first quantum dots having a surface modified with a first ligand and includes a second quantum dot layer located between the first quantum dot layer and the second electrode and including a plurality of second quantum dots having a surface modified with a second ligand that is different from the first ligand. The second quantum dot layer has an ionization potential greater than an ionization potential of the first quantum dot layer. A second value that represents a particle diameter distribution of the plurality of second quantum dots is less than a first value that represents a particle diameter distribution of the plurality of first quantum dots.

## Description

### Technical Field

The present disclosure relates to a photoelectric conversion element and an imaging device.

### Background Art

Studies have been actively conducted on photoelectric conversion elements in which semiconductor quantum dots are used as a photoelectric conversion material to utilize the quantum size effect. Semiconductor quantum dots are nanocrystals that are semiconductor microcrystals with a size of several nanometers. The quantum size effect is a phenomenon in which when electrons, holes, and excitons are confined within the nanocrystal, the energy state is discretized, and, consequently, a particle-size-dependent energy shift appears. As the particle size of semiconductor quantum dots, which are nanocrystals, decreases, the energy gap of the semiconductor quantum dots becomes larger than the energy gap of bulk crystals, and, accordingly, an absorption edge wavelength shifts to shorter wavelengths. That is, controlling the particle size of a semiconductor material enables the semiconductor material to have a light absorption wavelength tuned to any desired wavelength, with the upper limit thereof being the absorption edge wavelength of the bulk crystal. In the following description, the "semiconductor quantum dots" are also referred to simply as "quantum dots". In instances where quantum dots are used as a photoelectric conversion material, it is desirable that the quantum dots have a wide sensitive wavelength range suited to the application.

Patent Literature 1 discloses a technology that can broaden the sensitive wavelength range, and the technology involves forming a photoelectric conversion layer by mixing quantum dots of different particle sizes.

Patent Literature 2 discloses a technology that can broaden the sensitive wavelength range, and the technology involves stacking a layer formed of quantum dots having a small particle size and a layer formed of quantum dots having a large particle size, thereby modulating a bandgap at an interface therebetween.

Patent Literature 3 discloses a technology that improves the mobility of photogenerated carriers, and the technology involves varying thicknesses and components of ligand layers that modify a surface of quantum dots, thereby controlling the band structure and providing an energy band gradient between two quantum dot semiconductor layers.

### Citation List

### Patent Literature

PTL 1: Japanese Patent No. 6083813
PTL 2: Japanese Patent No. 6255417
PTL 3: Japanese Patent No. 6298223

### Summary of Invention

### Technical Problem

Unfortunately, while Patent Literature 1, Patent Literature 2, and Patent Literature 3 disclose the broadening of the sensitive wavelength range or an improvement in mobility associated with the use of quantum dots as a photoelectric conversion material, they do not provide disclosures about a dark current, which is important for realizing a high-performance photodiode and a high-performance imaging device. In photodiodes and imaging devices, the dark current directly affects a signal-to-noise (S/N) ratio. Accordingly, for their practical use, it is desirable that the dark current be lower than that of power generation elements such as solar cells by at least several orders of magnitude.

An object of the present disclosure is to provide photoelectric conversion elements and an imaging device that can have both an extended sensitive wavelength range and a reduced dark current.

### Solution to Problem

According to an aspect of the present disclosure, a photoelectric conversion element includes a photoelectric conversion layer, a first electrode, and a second electrode. The first electrode collects holes generated in the photoelectric conversion layer. The second electrode is positioned opposite to the first electrode with the photoelectric conversion layer being disposed between the second electrode and the first electrode and collects electrons generated in the photoelectric conversion layer. The photoelectric conversion layer includes a first quantum dot layer and a second quantum dot layer. The first quantum dot layer includes a plurality of first quantum dots having a surface modified with a first ligand. The second quantum dot layer is located between the first quantum dot layer and the second electrode and includes a plurality of second quantum dots having a surface modified with a second ligand that is different from the first ligand. The second quantum dot layer has an ionization potential greater than an ionization potential of the first quantum dot layer. A second value that represents a particle diameter distribution of the plurality of second quantum dots is less than a first value that represents a particle diameter distribution of the plurality of first quantum dots.

According to another aspect of the present disclosure, an imaging device includes a plurality of pixels, and the plurality of pixels each include the photoelectric conversion element.

According to another aspect of the present disclosure, a photoelectric conversion element includes a photoelectric conversion layer, a first electrode, and a second electrode. The first electrode collects holes generated in the photoelectric conversion layer. The second electrode is positioned opposite to the first electrode with the photoelectric conversion layer being disposed between the second electrode and the first electrode and collects electrons generated in the photoelectric conversion layer. The photoelectric conversion layer includes a first quantum dot layer and a second quantum dot layer. The first quantum dot layer includes a plurality of first quantum dots having a surface modified with a first ligand. The second quantum dot layer is located between the first quantum dot layer and the second electrode and includes a plurality of second quantum dots having a surface modified with a second ligand that is different from the first ligand. The second quantum dot layer has an ionization potential greater than an ionization potential of the first quantum dot layer. An absorption peak wavelength of the plurality of second quantum dots is shorter than an absorption peak wavelength of the plurality of first quantum dots. A material of the plurality of first quantum dots is different from a material of the plurality of second quantum dots.

### Advantageous Effects of Invention

Aspects of the present disclosure can provide both an extended sensitive wavelength range and a reduced dark current.

### Brief Description of Drawings

[Fig. 1] Fig. 1 is a schematic cross-sectional view of a configuration of a photoelectric conversion element according to a first embodiment.
[Fig. 2A] Fig. 2A is a schematic cross-sectional view of a configuration of another exemplary photoelectric conversion element according to the first embodiment.
[Fig. 2B] Fig. 2B is an illustration of an exemplary energy diagram of the photoelectric conversion element illustrated in Fig. 2A.
[Fig. 3] Fig. 3 is a diagram illustrating results of measurements of an ionization potential and an electron affinity of quantum dots, with a particle size and a surface-modifying ligand thereof being varied.
[Fig. 4] Fig. 4 is a diagram illustrating an exemplary circuit configuration of an imaging device according to a second embodiment.
[Fig. 5] Fig. 5 is a schematic cross-sectional view of a device structure of a pixel in the imaging device according to the second embodiment.
[Fig. 6] Fig. 6 is a diagram illustrating an exemplary circuit configuration of an imaging device according to a modification of the second embodiment.
[Fig. 7] Fig. 7 is a schematic cross-sectional view of a device structure of a pixel in the imaging device according to the modification of the second embodiment.
[Fig. 8] Fig. 8 is a diagram illustrating a relationship between an absorption peak wavelength and a diameter, regarding PbS quantum dots and PbSe quantum dots.
[Fig. 9A] Fig. 9A is a diagram illustrating absorption spectra of the PbS quantum dots and the PbSe quantum dots.
[Fig. 9B] Fig. 9B is a schematic cross-sectional view of a configuration of a photoelectric conversion element that employs a combination of quantum dots that have different constituent elements.
[Fig. 9C] Fig. 9C is an illustration of an exemplary energy diagram of the photoelectric conversion element illustrated in Fig. 9B.

### Description of Embodiments

### (Overview of the Present Disclosure)

An overview of aspects of the present disclosure is as follows.

According to an aspect of the present disclosure, a photoelectric conversion element includes a photoelectric conversion layer, a first electrode, and a second electrode. The first electrode collects holes generated in the photoelectric conversion layer. The second electrode is positioned opposite to the first electrode with the photoelectric conversion layer being disposed between the second electrode and the first electrode and collects electrons generated in the photoelectric conversion layer. The photoelectric conversion layer includes a first quantum dot layer and a second quantum dot layer. The first quantum dot layer includes a plurality of first quantum dots having a surface modified with a first ligand. The second quantum dot layer is located between the first quantum dot layer and the second electrode and includes a plurality of second quantum dots having a surface modified with a second ligand that is different from the first ligand. The second quantum dot layer has an ionization potential greater than an ionization potential of the first quantum dot layer. A second value that represents a particle diameter distribution of the plurality of second quantum dots is less than a first value that represents a particle diameter distribution of the plurality of first quantum dots.

As described, the photoelectric conversion layer includes the first quantum dots and the second quantum dots that have different respective particle diameters. As a result, a sensitive wavelength range can be extended, because an absorption wavelength of quantum dots depends on the particle diameter of the quantum dots. Furthermore, in the photoelectric conversion layer, the ionization potential of the second quantum dot layer located near the second electrode is greater than the ionization potential of the first quantum dot layer. As a result, excitons that are generated by absorption of light efficiently dissociate into electrons and holes at an interface between the first quantum dot layer and the second quantum dot layer. The holes migrate through the first quantum dot layer and are collected by the first electrode, and the electrons migrate through the second quantum dot layer and are collected by the second electrode. Thus, the electrical charges flow smoothly, which can improve photoelectric conversion efficiency. Furthermore, the second quantum dots have a particle diameter smaller than that of the first quantum dots. Consequently, the second quantum dot layer has a large bandgap, and, therefore, a difference between the ionization potential of the first quantum dot layer and an electron affinity of the second quantum dot layer is likely to increase. As a result, thermal excitation is unlikely to occur at the interface between the first quantum dot layer and the second quantum dot layer. Consequently, a dark current due to thermal excitation at the interface between the first quantum dot layer and the second quantum dot layer can be reduced. Accordingly, the photoelectric conversion element according to this aspect can have both an extended sensitive wavelength range and a reduced dark current.

Furthermore, for example, the plurality of first quantum dots and the plurality of second quantum dots may each independently include at least one of CdSe, CdS, PbS, PbSe, PbTe, ZnO, ZnS, Cu₂ZnSnS₄, Cu₂S, Bi₂S₃, CuInSe₂, AgInS₂, AgInTe₂, CdSnAs₂, ZnSnAs₂, ZnSnSb₂, Ag₂S, Ag₂Te, HgTe, CdHgTe, Ge, GeSn, InAs, and InSb. In other words, the plurality of first quantum dots and the plurality of second quantum dots may each independently include at least one selected from the group consisting of CdSe, CdS, PbS, PbSe, PbTe, ZnO, ZnS, Cu₂ZnSnS₄, Cu₂S, Bi₂S₃, CuInSe₂, AgInS₂, AgInTe₂, CdSnAs₂, ZnSnAs₂, ZnSnSb₂, Ag₂S, Ag₂Te, HgTe, CdHgTe, Ge, GeSn, InAs, and InSb.

Combining any of these enables the sensitive wavelength of the photoelectric conversion element to be controlled as desired over a broad wavelength range from visible to infrared.

Furthermore, for example, the first ligand may have a first dipole moment, the second ligand may have a second dipole moment, and the first dipole moment may be greater than the second dipole moment provided that the first dipole moment is positive when the first dipole moment points outside of each of the plurality of first quantum dots, and that the second dipole moment is positive when the second dipole moment points outside of each of the plurality of second quantum dots.

In this case, the ionization potential of the first quantum dot layer can be easily reduced by the first ligand, and the ionization potential of the second quantum dot layer can be easily increased by the second ligand. Accordingly, an ionization potential of the second quantum dot layer greater than the ionization potential of the first quantum dot layer can be easily achieved, and, consequently, a photoelectric conversion element having both an extended sensitive wavelength range and a reduced dark current can be realized.

Furthermore, for example, the first ligand may be 1,4-benzenedithiol, and the second ligand may be a mixture of ZnI₂ and 3-mercaptopropionic acid.

In this case, an extended sensitive wavelength range and a reduced dark current can be effectively achieved.

Furthermore, for example, at least one of the particle diameter distribution of the plurality of first quantum dots and the particle diameter distribution of the plurality of second quantum dots may have at least two different local maximum values. In other words, at least one selected from the group consisting of the particle diameter distribution of the plurality of first quantum dots and the particle diameter distribution of the plurality of second quantum dots may have at least two different local maximum values.

In this case, the sensitive wavelength range of the photoelectric conversion element can be further extended.

According to another aspect of the present disclosure, an imaging device includes a plurality of pixels, and the plurality of pixels each include the photoelectric conversion element.

Since the imaging device includes the photoelectric conversion element, the imaging device can have both an extended sensitive wavelength range and a reduced dark current.

Furthermore, for example, the imaging device may further include a signal readout circuit connected to the first electrode and include a voltage supply circuit that provides a voltage to the second electrode, the voltage being a voltage in which a potential of the second electrode is positive with respect to a potential of the first electrode.

In this case, with the use of the photoelectric conversion element, the imaging device can read out the holes collected by the first electrode, which serve as signal charges.

Alternatively, for example, the imaging device may further include a signal readout circuit connected to the second electrode and include a voltage supply circuit that provides a voltage to the first electrode, the voltage being a voltage in which a potential of the first electrode is negative with respect to a potential of the second electrode.

In this case, with the use of the photoelectric conversion element, the imaging device can read out the electrons collected by the second electrode, which serve as signal charges.

According to another aspect of the present disclosure, a photoelectric conversion element includes a photoelectric conversion layer, a first electrode, and a second electrode. The first electrode collects holes generated in the photoelectric conversion layer. The second electrode is positioned opposite to the first electrode with the photoelectric conversion layer being disposed between the second electrode and the first electrode and collects electrons generated in the photoelectric conversion layer. The photoelectric conversion layer includes a first quantum dot layer and a second quantum dot layer. The first quantum dot layer includes a plurality of first quantum dots having a surface modified with a first ligand. The second quantum dot layer is located between the first quantum dot layer and the second electrode and includes a plurality of second quantum dots having a surface modified with a second ligand that is different from the first ligand. The second quantum dot layer has an ionization potential greater than an ionization potential of the first quantum dot layer. An absorption peak wavelength of the plurality of second quantum dots is shorter than an absorption peak wavelength of the plurality of first quantum dots. A material of the plurality of first quantum dots is different from a material of the plurality of second quantum dots.

Furthermore, for example, a second value that represents a particle diameter distribution of the plurality of first quantum dots may be equal to a first value that represents a particle diameter distribution of the plurality of second quantum dots.

Alternatively, for example, a second value that represents a particle diameter distribution of the plurality of second quantum dots may be greater than a first value that represents a particle diameter distribution of the plurality of first quantum dots.

Embodiments of the present disclosure will now be described with reference to the drawings.

Note that all the embodiments described below present a generic or specific example. The numerical values, shapes, constituent elements, placement positions and forms of connection of the constituent elements, steps, orders of the steps, and the like that are presented in the embodiments described below are merely illustrative and are not intended to limit the present disclosure. Furthermore, of the constituent elements described in the present embodiments below, constituent elements not recited in the independent claims are described as optional constituent elements. Furthermore, the drawings are not necessarily precise illustrations. Accordingly, the drawings are not necessarily to scale, for example. Furthermore, in the drawings, substantially the same components are assigned the same reference signs, and redundant descriptions may be omitted or simplified.

Furthermore, in this specification, terms indicating a relationship between elements, terms indicating a shape of an element, and numerical ranges do not necessarily have strict meanings; that is, substantially equivalent ranges that differ, for example, by approximately several percent are also encompassed.

Furthermore, in this specification, the terms "above" and "below" do not refer to an upward (vertically upper) direction or a downward (vertically lower) direction based on an absolute space recognition, and the terms define relative positional relationships based on a stacking order of a stack configuration. Note that terms such as "above" and "below" are used to specify a mutual arrangement of components and are not intended to limit an orientation of an imaging device during use. Furthermore, the terms "above" and "below" are used not only in instances in which two constituent elements are spaced from each other with a different constituent element being present between the two constituent elements but also in instances in which two constituent elements are disposed on each other, that is, the two constituent elements are in contact with each other.

Furthermore, in this specification, electromagnetic waves in general, including visible light, infrared light, and ultraviolet light, are referred to as "light" for convenience.

### (First Embodiment)

### [Overall Configuration]

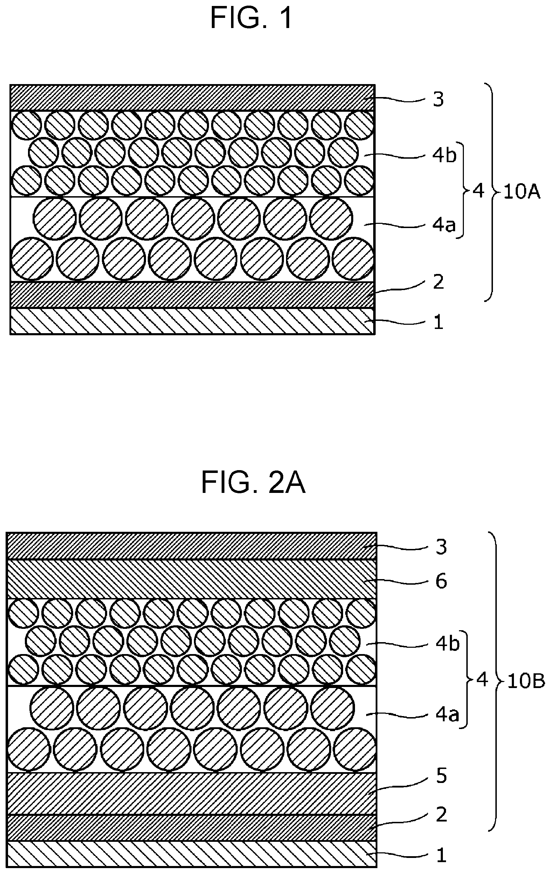

First, an overall configuration of a photoelectric conversion element according to the present embodiment will be described. Fig. 1 is a schematic cross-sectional view of a configuration of a photoelectric conversion element 10A, according to the present embodiment. As illustrated in Fig. 1, the photoelectric conversion element 10A includes a pair of electrodes, namely, a first electrode 2 and a second electrode 3, and a photoelectric conversion layer 4, which is located between the first electrode 2 and the second electrode 3. The photoelectric conversion layer 4 includes a first quantum dot layer 4a and a second quantum dot layer 4b. The first quantum dot layer 4a includes first quantum dots. The second quantum dot layer 4b is located between the first quantum dot layer 4a and the second electrode 3 and includes second quantum dots that have a particle size smaller than that of the first quantum dots. That is, the photoelectric conversion layer 4 is configured as a stack of the first quantum dot layer 4a and the second quantum dot layer 4b that include quantum dots having different respective particle sizes. The first quantum dot layer 4a is in contact with the second quantum dot layer 4b. The photoelectric conversion element 10A is supported on a substrate 1. The first electrode 2, the first quantum dot layer 4a, the second quantum dot layer 4b, and the second electrode 3 of the photoelectric conversion element 10A are stacked in this order on one of the major surfaces of the substrate 1.

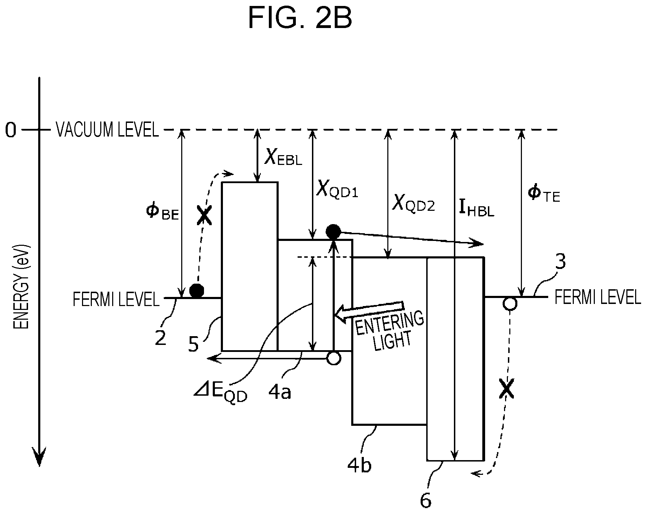

The photoelectric conversion element 10A may further include an electron blocking layer and a hole blocking layer. Fig. 2A is a schematic cross-sectional view of a configuration of a photoelectric conversion element 10B, which is another example of the present embodiment. Fig. 2B is an illustration of an exemplary energy diagram of the photoelectric conversion element 10B, illustrated in Fig. 2A. In Fig. 2B, the difference between a vacuum level and an upper end of an energy band corresponds to an electron affinity, and the difference between the vacuum level and a lower end of the energy band corresponds to an ionization potential. The difference between a Fermi level and the vacuum level corresponds to a work function. Note that an exemplary energy diagram of the photoelectric conversion element 10A, illustrated in Fig. 1, is a diagram that is similar to Fig. 2B but in which the energy bands of an electron blocking layer 5 and a hole blocking layer 6 are not included.

As illustrated in Fig. 2A, the photoelectric conversion element 10B includes the electron blocking layer 5 and the hole blocking layer 6, in addition to the components of the photoelectric conversion element 10A. The electron blocking layer 5 is located between the first electrode 2 and the first quantum dot layer 4a, and the hole blocking layer 6 is located between the second electrode 3 and the second quantum dot layer 4b. The first electrode 2, the electron blocking layer 5, the first quantum dot layer 4a, the second quantum dot layer 4b, the hole blocking layer 6, and the second electrode 3 of the photoelectric conversion element 10B are stacked in this order on one of the major surfaces of a substrate 1. This configuration can reduce a dark current that may be generated when a reverse bias voltage is applied for photoelectric conversion. Details will be described later.

Now, details of the components of the photoelectric conversion elements of the present embodiment will be described.

### [Substrate]

The substrate 1 is a supporting substrate that supports the photoelectric conversion element 10A and the photoelectric conversion element 10B. A material of the substrate 1 is not particularly limited and may be any of a variety of materials. For example, the substrate 1 may be a p-type silicon substrate or a glass or plastic substrate coated with a conductive metal oxide, such as ITO (indium tin oxide), or with a conductive polymer, such as polyacetylene. The substrate 1 is, for example, transmissive to at least a portion of light of a wavelength that is absorbed by the photoelectric conversion layer 4.

In the illustrated examples, the substrate 1 is disposed adjacent to the first electrode 2 of the photoelectric conversion element 10A and the photoelectric conversion element 10B. Alternatively, the substrate 1 may be disposed adjacent to the second electrode 3 of the photoelectric conversion element 10A and the photoelectric conversion element 10B.

### [First Electrode and Second Electrode]

The first electrode 2 and the second electrode 3 are electrodes in the form of a film, for example. The first electrode 2 is a hole-collecting electrode that collects holes generated in the photoelectric conversion layer 4, and the second electrode 3 is an electron-collecting electrode that collects electrons generated in the photoelectric conversion layer 4. The second electrode 3 is positioned opposite to the first electrode 2 with the photoelectric conversion layer 4 being disposed between the second electrode 3 and the first electrode 2.

At least one of the first electrode 2 and the second electrode 3 is a transparent electrode that is highly transmissive to light over a desired wavelength range. A desired wavelength is, for example, a wavelength range including absorption peaks of the first quantum dots and the second quantum dots. Furthermore, in this specification, "being highly transmissive to light at a certain wavelength" means, for example, that a light transmittance at the wavelength is greater than or equal to 50% or may mean that the light transmittance is greater than or equal to 80%.

A bias voltage is applied across the first electrode 2 and the second electrode 3 via an interconnect (not illustrated), for example. A polarity of the bias voltage is determined, for example, such that the electrons of the electron-hole pairs generated in the photoelectric conversion layer 4 can move to the second electrode 3, and the holes thereof can move to the first electrode 2. Specifically, a bias voltage in which a potential of the second electrode 3 is positive with respect to a potential of the first electrode 2 is applied. Accordingly, the first electrode 2 collects the holes, and the second electrode 3 collects the electrons. It is also possible to enable the holes to be collected by the first electrode 2 and the electrons to be collected by the second electrode 3 by reducing the work function of the second electrode 3 with respect to the work function of the first electrode 2

In instances where the first electrode 2 and the second electrode 3 are highly transmissive to light over a desired wavelength range, examples of materials thereof include a transparent conducting oxide (TCO) with a low resistance value. Examples of the TCO include, but are not limited to, ITO, IZO (InZnO: indium zinc oxide), AZO (AlZnO: aluminum zinc oxide), FTO (fluorine-doped tin oxide), SnO₂, TiO₂, and ZnO₂.

Other examples of the materials of the first electrode 2 and the second electrode 3 include Al, Cu, Ti, TiN, Ta, TaN, Mo, Ru, In, Mg, Ag, Au, and Pt.

### [Photoelectric Conversion Layer]

Hole-electron pairs, which are excitons, are produced in the photoelectric conversion layer 4 when light enters the photoelectric conversion layer 4. The photoelectric conversion layer 4 includes, as photoelectric conversion materials, quantum dots having different particle sizes so that a sensitive wavelength range of the photoelectric conversion element 10A can be extended. A quantum dot is a nanocrystal having a diameter of approximately 2 nm to 10 nm and formed of approximately dozens of atoms. Examples of materials of the quantum dots include group IV semiconductors, such as Si and Ge, group IV-VI semiconductors, such as PbS, PbSe, and PbTe, group III-V semiconductors, such as InAs and InSb, and ternary mixed crystals, such as HgCdTe and PbSnTe.

Specifically, the photoelectric conversion layer 4 includes the first quantum dot layer 4a, which includes the first quantum dots, and the second quantum dot layer 4b, which includes the second quantum dots. The first quantum dot layer 4a and the second quantum dot layer 4b each generate hole-electron pairs upon absorption of light. In the photoelectric conversion layer 4, the first quantum dot layer 4a is located adjacent to the first electrode 2, which is a hole-collecting electrode, and the second quantum dot layer 4b is located adjacent to the second electrode 3, which is an electron-collecting electrode. The first quantum dots and the second quantum dots may each independently include, for example, at least one of CdSe, CdS, PbS, PbSe, PbTe, ZnO, ZnS, Cu₂ZnSnS₄ (CZTS), Cu₂S, Bi₂S₃, CuInSe₂, AgInS₂, AgInTe₂, CdSnAs₂, ZnSnAs₂, ZnSnSb₂, Ag₂S, Ag₂Te, HgTe, CdHgTe, Ge, GeSn, InAs, and InSb. Using any of these enables the sensitive wavelength of the photoelectric conversion element to be freely controlled over a broad wavelength range from visible to infrared.

A second value that represents a particle diameter distribution of the plurality of second quantum dots is less than a first value that represents a particle diameter distribution of the plurality of first quantum dots. The first value and the second value are measured values of modal diameters that are local maximum values in a particle diameter distribution of the particles in an instance in which, for example, the distribution is expressed as a frequency distribution by using, for instance, a transmission electron microscope. Furthermore, for example, the second value may be a maximum value among the particle diameters exhibiting the local maximum values in the particle diameter distribution of the second quantum dots, and the first value may be a minimum value among the particle diameters exhibiting the local maximum values in the particle diameter distribution of the first quantum dots. Note that the first value and the second value may each be an average particle diameter that is an average of the particle diameters of multiple quantum dots that are randomly selected from each of the layers.

Furthermore, at least one of the particle diameter distribution of the first quantum dots and the particle diameter distribution of the second quantum dots may have at least two different local maximum values. In this case, the sensitive wavelength range of the photoelectric conversion element 10A can be further extended. In the instance where a particle diameter distribution of quantum dots has at least two different local maximum values, the particle diameter is, for example, an average of the particle diameters indicated by the at least two local maximum values.

Furthermore, since an absorption peak wavelength of quantum dots depends on the particle diameter, the particle diameter of quantum dots can be represented by the absorption peak wavelength. For example, the absorption peak wavelength of quantum dots corresponds to the modal diameter of the quantum dots. Specifically, quantum dots with longer absorption peak wavelengths have larger particle diameters, and quantum dots with shorter absorption peak wavelengths have smaller particle diameters. Accordingly, the first quantum dots have an absorption peak at a wavelength longer than the absorption peak wavelength of the second quantum dots. Furthermore, the first quantum dots may have an absorption peak at a wavelength longer than the absorption peak wavelength of the second quantum dots by 100 nm or greater.

The particle size of the quantum dots can be controlled by adjusting a reaction time and temperature in an existing method for growing quantum dots. Accordingly, quantum dots having, for example, a substantially uniform particle diameter can be obtained. Examples of the quantum dots having a uniform particle diameter include quantum dots having a single absorption peak in a near-infrared range. The first quantum dots and the second quantum dots may each be formed of one type of quantum dots having a uniform particle diameter or may be formed of multiple types of quantum dots with each type having a uniform particle diameter. In the instance where the first quantum dots and the second quantum dots are each formed of multiple types of quantum dots with each type having a uniform particle diameter, a minimum particle diameter of the particle diameters of the multiple types of quantum dots that form the first quantum dots is greater than a maximum particle diameter of the particle diameters of the multiple types of quantum dots that form the second quantum dots.

The first quantum dots and the second quantum dots may each have an absorption peak in the near-infrared range. Furthermore, at least one of the first quantum dots and the second quantum dots may have multiple absorption peaks in the near-infrared range. In the instance where at least one of the first quantum dots and the second quantum dots have multiple absorption peaks in the near-infrared range, the longest absorption peak wavelength of the second quantum dots is shorter than the shortest absorption peak wavelength of the first quantum dots, in the near-infrared range.

The first quantum dots and the second quantum dots not only have different respective particle sizes but also are coated with different respective surface-modifying ligands. Specifically, a surface of the first quantum dots is modified with a first ligand, and a surface of the second quantum dots is modified with a second ligand that is different from the first ligand.

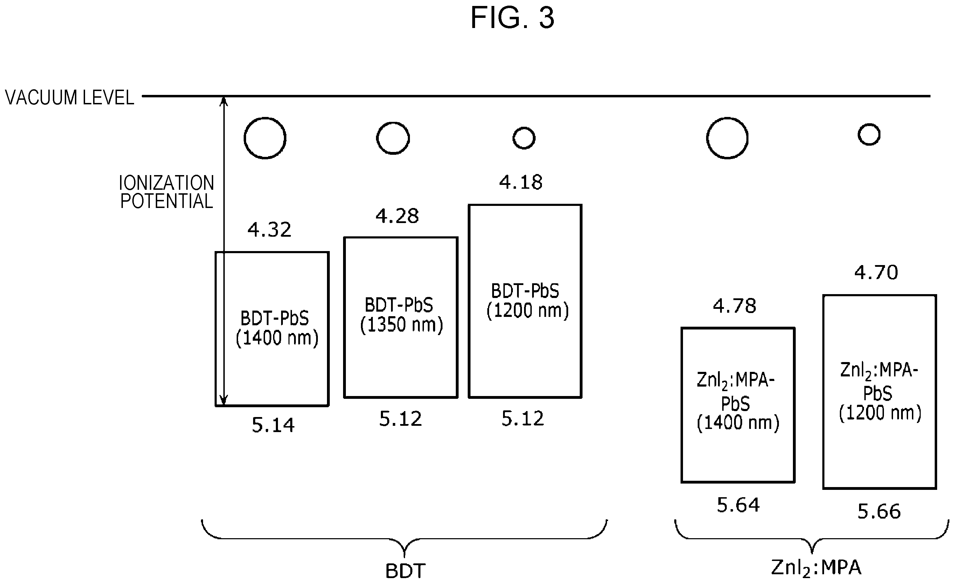

Fig. 3 is a diagram illustrating results of measurements of the ionization potential and the electron affinity of quantum dots, with the particle size and the surface-modifying ligand thereof being varied.

The measurement of the ionization potential was performed with a photoelectron yield spectrometer (AC-3, manufactured by Riken Keiki Co., Ltd.) under a nitrogen atmosphere. The number of photoelectrons was measured at various levels of UV radiation energy, and the ionization potential was determined as the energy location at which photoelectrons began to be detected. The measurement of the electron affinity was performed as follows. First, an absorption spectrum of the quantum dots was measured, and then, an optical bandgap was calculated from the result of an absorption edge wavelength of the obtained absorption spectrum. Thereafter, the electron affinity was calculated from the ionization potential, which was measured in the described manner, and the calculated optical bandgap. In Fig. 3, the values shown below the energy bands are the ionization potentials, and the values shown above the energy bands are the electron affinities. The surface-modifying ligands used were 1,4-benzenedithiol (1,4-BDT) and ZnI₂:MPA (zinc iodide:3-mercaptopropionic acid). In Fig. 3, the 1,4-BDT is denoted simply as "BDT". "ZnI₂:MPA" means a "mixture of ZnI₂ and MPA". The quantum dots used were quantum dots formed of PbS and having an absorption peak wavelength of 1200 nm, quantum dots formed of PbS and having an absorption peak wavelength of 1350 nm, and quantum dots formed of PbS and having an absorption peak wavelength of 1400 nm. In Fig. 3, the wavelengths shown within the energy bands are the absorption peak wavelengths of the respective sets of quantum dots.

As shown in Fig. 3, the ionization potentials of quantum dots are independent of the particle size and substantially the same value when the surface-modifying ligands are of the same type. Specifically, the ionization potentials of the quantum dots modified with BDT used as a surface-modifying ligand are 5.12 eV to 5.14 eV, and the ionization potentials of the quantum dots modified with ZnI₂:MPA used as a surface-modifying ligand are 5.64 eV to 5.66 eV.

As illustrated in Fig. 2B, in the present embodiment, the ionization potential of the second quantum dot layer 4b, which includes the second quantum dots modified with the second ligand, is greater than the ionization potential of the first quantum dot layer 4a, which includes the first quantum dots having a surface modified with the first ligand. That is, the second ligand is a surface-modifying ligand that can increase the ionization potential of quantum dots to a greater extent than the first ligand. The difference between the ionization potential of the first quantum dot layer 4a and the ionization potential of the second quantum dot layer 4b is, for example, greater than or equal to 0.1 eV and less than or equal to 0.7 eV. Furthermore, the electron affinity of the second quantum dot layer 4b is greater than the electron affinity of the first quantum dot layer 4a. The difference between the electron affinity of the first quantum dot layer 4a and the electron affinity of the second quantum dot layer 4b is, for example, greater than or equal to 0.1 eV and less than or equal to 0.6 eV.

Accordingly, in the present embodiment, regarding a comparison between the ionization potential and the electron affinity, the first quantum dot layer 4a, which has relatively low values thereof, is positioned nearer the first electrode 2, which collects holes, than is the second quantum dot layer 4b, and the second quantum dot layer 4b, which has relatively high values of the ionization potential and the electron affinity, is positioned nearer the second electrode 3, which collects electrons, than is the first quantum dot layer 4a. That is, a configuration is realized in which when the electron-hole pairs, which are excitons generated by the entrance of light, are dissociated, the holes are collected by the first electrode 2, and the electrons are collected by the second electrode 3, in the absence of an energy barrier under the bias voltage, which is described above. In such a configuration, an interface between the first quantum dot layer 4a and the second quantum dot layer 4b can be regarded as a heterojunction interface. An energy difference at the heterojunction interface and an electric field of a depletion layer formed at the interface enable the excitons generated by the absorption of light to be dissociated into electrons and holes, and, accordingly, photoelectric conversion efficiency, that is, quantum efficiency, is improved.

Furthermore, since the second quantum dot layer 4b, which is positioned adjacent to the second electrode 3 that collects electrons, is formed of quantum dots having a particle size smaller than that of the first quantum dot layer 4a, which is positioned adjacent to the first electrode 2 that collects holes, a dark current that may be thermally induced at the interface between the first quantum dot layer 4a and the second quantum dot layer 4b can be reduced. It is presumed that the dark current that may be thermally induced is correlated with an energy difference ΔE_{QD} at the interface between the first quantum dot layer 4a and the second quantum dot layer 4b, illustrated in Fig. 2B. In the present embodiment, the energy difference ΔE_{QD} is a difference between the ionization potential of the first quantum dot layer 4a and the electron affinity of the second quantum dot layer 4b. When the energy difference ΔE_{QD} is large, thermal excitation is less likely to occur at the interface between the first quantum dot layer 4a and the second quantum dot layer 4b, and, consequently, the dark current is reduced.

As described above, the ionization potential of quantum dots is independent of the particle size and depends on the surface-modifying ligand. On the other hand, an energy gap of quantum dots depends on the particle size. Quantum dots with smaller particle sizes, that is, larger energy gaps, tend to have lower electron affinities. Accordingly, as described above, when the ionization potential of the second quantum dot layer 4b is greater than the ionization potential of the first quantum dot layer 4a, because of the surface-modifying ligand, the smaller the particle size of the second quantum dots that are included in the second quantum dot layer 4b, the larger the energy gap of the second quantum dot layer 4b, and, consequently, the larger the energy difference ΔE_{QD}. Thus, a stack configuration (I) can increase the energy difference ΔE_{QD} to a greater extent than a stack configuration (II), where the stack configuration (I) is constituted by (i) the first quantum dot layer 4a made of a combination of the first ligand and the first quantum dots and (ii) the second quantum dot layer 4b made of a combination of the second ligand and the second quantum dots, and the stack configuration (II) is constituted by (i) a quantum dot layer made of a combination of the first ligand and the second quantum dots and (ii) a quantum dot layer made of a combination of the second ligand and the first quantum dots. Consequently, a photoelectric conversion element having a further reduced dark current can be realized.

As described above with reference to Fig. 3, the ionization potential of quantum dots varies depending on the type of surface-modifying ligand. Specifically, the ionization potential of a quantum dot film having a surface modified with a surface-modifying ligand can be explained by a total sum of a dipole moment of the surface-modifying ligand and a dipole moment of an electric double layer at an interface between the surface-modifying ligand and the quantum dots, and the ionization potential varies depending on a net effective dipole moment felt by the quantum dots. The dipole moment is expressed as a vector extending from a partial charge δ- to a partial charge δ+, and the dipole moment of a surface-modifying ligand is a vector sum of the dipole moments of bonds present in the surface-modifying ligand compound. For example, in the instance of PbS quantum dots, the surface-modifying ligand is primarily coordinated to the element Pb on the surface, and, therefore, the dipole moment at the interface between the surface-modifying ligand and the quantum dots points from the surface of the quantum dots to an inside thereof. In this instance, when the dipole moment of the surface-modifying ligand is one that points outside of the quantum dots, the dipole moment acts to cancel the dipole moment at the interface between the surface-modifying ligand and the quantum dots, and, therefore, the ionization potential tends to be reduced. On the contrary, when the dipole moment of the surface-modifying ligand is one that points inside of the quantum dots, the ionization potential tends to be increased. That is, the ionization potential can be modulated according to the magnitude of the dipole moment of the surface-modifying ligand.

In instances where two types of surface-modifying ligands in which the dipole moments of the surface-modifying ligands have the same direction are compared, the ionization potential varies depending on the magnitude relationship between the magnitudes of the dipole moments. For example, in instances where in two different types of surface-modifying ligands, the dipole moments of the surface-modifying ligands point outside of the quantum dots, one of the surface-modifying ligands that has a larger dipole moment tends to provide a lower ionization potential. That is, assuming that the dipole moment of a surface-modifying ligand adsorbed on the surface of quantum dots is positive when the dipole moment points outside of the quantum dots, larger dipole moments of a surface-modifying ligand in the positive direction tend to result in lower ionization potentials, and, on the contrary, larger dipole moments in the negative direction tend to result in higher ionization potentials. Note that in instances where the surface-modifying ligand is one in which the dipole moment cannot be defined, such as ions of elements, the dipole moment at the interface between the surface-modifying ligand and the quantum dots becomes dominant. The dipole moment of the surface-modifying ligand and the dipole moment at the interface between the surface-modifying ligand and the quantum dots can be determined by calculation based on the density functional theory.

The surface-modifying ligand may be any ligand as long as the ligand can be coordinated to quantum dots. For example, the surface-modifying ligand may be an organic compound, such as an alkyl ammonium salt or a thiol, or may be an inorganic compound, such as a halide salt. The halide salt may be used as a mixture of the halide salt and a carboxylic acid terminated thiol, such as 3-mercaptopropionic acid.

Specifically, examples of the surface-modifying ligand that has a positive charge on the side opposite to the quantum dot-side of the surface-modifying ligand and has a dipole moment pointing outside of the quantum dots include compounds having a structure in which, when a thiol group is coordinated, a localized positive charge is created on an opposite side. Examples of the compounds include 1,2-ethanedithiol (1,2-EDT) and 1,4-benzenedithiol (1,4-BDT). Other examples of the surface-modifying ligand that has a dipole moment pointing outside of the quantum dots include compounds having a carboxyl group that is coordinated to the surface of the quantum dots and having an electron-donating group on a side opposite to that of the carboxyl group, and examples of the compounds include 4-methoxycinnamic acid. Examples of the surface-modifying ligand that has a dipole moment pointing outside of the quantum dots include compounds having a backbone that enables a coordination in which an electron-donating moiety, such as a phenol or an aniline, is positioned on an outer side with respect to the quantum dots.

Examples of the surface-modifying ligand that has a negative charge on the side opposite to the quantum dot-side of the surface-modifying ligand and has a dipole moment pointing inside of the quantum dots include halogen-ion-containing compounds, such as lead halide; zinc halide; mixtures of either of these and 3-mercaptopropionic acid; and tetrabutylammonium halides. Examples of the halogen include chlorine, bromine, and iodine. Other examples of the surface-modifying ligand that has a dipole moment pointing inside of the quantum dots include compounds having a backbone that enables a coordination in which an electron-withdrawing moiety, such as a cyano group, a carbonyl group, or a nitro group, is positioned on an outer side with respect to the quantum dots.

In many cases, available quantum dots have a surface modified with a surface-modifying ligand containing a long-chain alkyl so that high dispersibility can be achieved during synthesis. Since the surface-modifying ligand containing a long-chain alkyl hinders the movement of charges, the surface-modifying ligand is displaced with the first ligand or the second ligand. Known methods for the displacement include solid-state displacement methods, in which quantum dots are formed into a film (solid phase) and subsequently exposed to a solution of a displacing surface-modifying ligand, to accomplish displacement by using a difference in a concentration and a difference in a binding energy between the ligands; and liquid-state displacement methods, in which displacement between the surface-modifying ligands is carried out in a solution (liquid phase). Any of these known methods may be used.

In the present embodiment, for example, the first ligand has a first dipole moment, and the second ligand has a second dipole moment. The first dipole moment is greater than the second dipole moment provided that the first dipole moment is positive when the first dipole moment points outside of the first quantum dots, and that the second dipole moment is positive when the first dipole moment points outside of the second quantum dots. That is, subtracting the second dipole moment from the first dipole moment gives a positive dipole moment. Consequently, the ionization potential of the second quantum dot layer 4b can be easily made to be greater than the ionization potential of the first quantum dot layer 4a. For example, the first dipole moment may be a positive dipole moment pointing outside of the first quantum dots, and the second dipole moment may be a negative dipole moment pointing inside of the second quantum dots. Specifically, the first ligand may be a thiol-group-containing compound, such as 1,4-benzenedithiol, and the second ligand may be a halogen-ion-containing compound, such as a mixture of ZnI₂ and 3-mercaptopropionic acid. Combining such surface-modifying ligands facilitates improvement in photoelectric conversion efficiency while reducing the dark current.

### [Electron Blocking Layer and Hole Blocking Layer]

In the present embodiment, the holes of the hole-electron pairs generated in the photoelectric conversion layer 4 are collected by the first electrode 2, and the electrons thereof are collected by the second electrode 3. In this process, there is a possibility that charges with polarities opposite to those of the respective charges collected by the first electrode 2 and the second electrode 3 may be injected into the photoelectric conversion layer 4 from the first electrode 2 and the second electrode 3. These charges injected from the electrodes are a cause of a dark current that flows regardless of whether light enters the photoelectric conversion layer 4.

Accordingly, photoelectric conversion elements of the present embodiment may include the electron blocking layer 5, which is used for suppressing the dark current, between the first electrode 2 and the first quantum dot layer 4a, as in the photoelectric conversion element 10B, illustrated in Fig. 2A. As illustrated in Fig. 2B, the electron blocking layer 5 is a layer that serves as a barrier against the injection of electrons from the first electrode 2. For example, an electron affinity χ_{EBL} of the electron blocking layer 5 is comparable to or less than an electron affinity χ_{QD1} of the first quantum dot layer 4a so as to suppress a dark current due to the injection of electrons from the first electrode 2. Furthermore, for example, an ionization potential I_{EBL} of the electron blocking layer 5 is comparable to or less than an upper limit so as not to hinder the conduction of holes from the first quantum dot layer 4a to the first electrode 2; the upper limit is a value 0.5 eV greater than an ionization potential I_{QD1} of the first quantum dot layer 4a. As referred to herein, the ionization potential corresponds to a difference between the vacuum level and the energy level of the highest occupied molecular orbital (HOMO) or the upper edge of the valence band.

For example, a material of the electron blocking layer 5 is a material that satisfies the relationships regarding the electron affinity and the ionization potential. The material is, for example, a p-type semiconductor. The material of the electron blocking layer 5 may be an organic material, such as [N4,N4'-di(naphthalen-1-yl)-N4,N4'-bis(4-vinylphenyl)biphenyl-4,4'-diamine] (VNPB) or poly[N,N'-bis(4-butylphenyl)-N,N'-bis(phenyl)-benzidine] (poly-TPD), or a metal oxide, such as NiO, CoO, Co₃O₄, Cr₂O₃, Cu₂O, or CuO.

Likewise, photoelectric conversion elements of the present embodiment may include the hole blocking layer 6 between the second electrode 3 and the second quantum dot layer 4b, as in the photoelectric conversion element 10B, illustrated in Fig. 2A. As illustrated in Fig. 2B, the hole blocking layer 6 is a layer that serves as a barrier against the injection of holes from the second electrode 3. In this instance, for example, an ionization potential I_{HBL} of the hole blocking layer 6 is comparable to or greater than an ionization potential I_{QD2} of the second quantum dot layer 4b so as to suppress a dark current due to the injection of holes from the second electrode 3. Furthermore, for example, an electron affinity χ_{HBL} of the hole blocking layer 6 is comparable to or greater than an electron affinity χ_{QD2} of the second quantum dot layer 4b so as not to hinder the conduction of electrons from the second quantum dot layer 4b to the second electrode 3.

For example, a material of the hole blocking layer 6 is a material that satisfies the relationships regarding the electron affinity and the ionization potential. The material is, for example, an n-type semiconductor. Examples of the material of the hole blocking layer 6 include bathocuproine (BCP), bathophenanthroline (BPhen), fullerenes, zinc oxide, aluminum-doped zinc oxide, titanium oxide, and tin oxide.

The electron blocking layer 5 has hole conductivity for transporting holes. The hole blocking layer 6 has electron conductivity for transporting electrons. Accordingly, since the first quantum dot layer 4a is in contact with the electron blocking layer 5, the first quantum dot layer 4a is electrically connected to the first electrode 2 via the electron blocking layer 5. Furthermore, since the second quantum dot layer 4b is in contact with the hole blocking layer 6, the second quantum dot layer 4b is electrically connected to the second electrode 3 via the hole blocking layer 6.

Note that the photoelectric conversion element 10B need not necessarily include both of the electron blocking layer 5 and the hole blocking layer 6.

### (Second Embodiment)

Now, a second embodiment will be described. The second embodiment describes an imaging device that uses a photoelectric conversion element of the first embodiment. In the following description of the second embodiment, differences from the first embodiment will be mainly described, and descriptions of common features will be omitted or simplified.

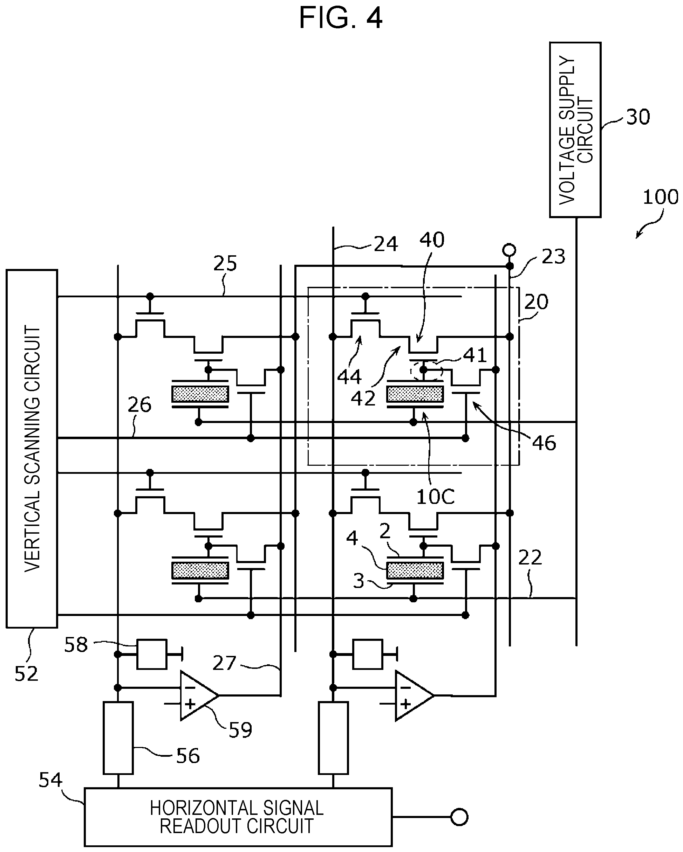

First, an overall configuration of the imaging device according to the present embodiment will be described. Fig. 4 is a diagram illustrating an exemplary circuit configuration of an imaging device 100, according to the present embodiment. The imaging device 100, illustrated in Fig. 4, includes a plurality of pixels 20 and peripheral circuits. The peripheral circuits include a voltage supply circuit 30, which provides a predetermined voltage to each of the pixels 20.

The pixels 20 are arranged on a semiconductor substrate one-dimensionally or two-dimensionally to form a light-sensitive area, which is a so-called pixel area. In the configuration illustrated in Fig. 4, the pixels 20 are arranged in a row direction and a column direction. In this specification, the row direction and the column direction are directions in which rows and columns respectively extend. That is, the column direction is a vertical direction, and the row direction is a horizontal direction, as viewed in Fig. 4. Fig. 4 illustrates four pixels 20 that are arranged in a 2×2 matrix. The number of the pixels 20 illustrated in Fig. 4 is merely an example provided for illustrative purposes, and, therefore, the number of the pixels 20 is not limited to four. In the instance where the pixels 20 are arranged one-dimensionally, the imaging device 100 is a line sensor.

The plurality of pixels 20 each include a photoelectric converter 10C and a signal detection circuit 40, which detects a signal generated by the photoelectric converter 10C. The signal detection circuit 40 is an example of a signal readout circuit. The photoelectric converter 10C includes the first electrode 2, the second electrode 3, and the photoelectric conversion layer 4 disposed therebetween. For example, the photoelectric converter 10C is formed of the photoelectric conversion element 10A or the photoelectric conversion element 10B of the first embodiment. The first electrode 2 serves as a charge collector. The signal detection circuit 40 is connected to the first electrode 2. The second electrode 3 is connected to the voltage supply circuit 30 via a storage control line 22. In the operation of the imaging device 100, a predetermined bias voltage is applied to the second electrode 3 via the storage control line 22. In the present embodiment, the first electrode 2 is a pixel electrode that collects signal charges, and the second electrode 3 is a counter electrode positioned opposite to the pixel electrode.

The photoelectric converter 10C has a configuration in which the holes (i.e., positive charges) of the electron-hole pairs generated by photoelectric conversion are collected as signal charges by the first electrode 2. Controlling the potential of the second electrode 3 by using a bias voltage generated by the voltage supply circuit 30 enables the holes to be collected by the first electrode 2. The voltage supply circuit 30 provides a voltage to the second electrode 3 via the storage control line 22. The voltage is a voltage in which the potential of the second electrode 3 is positive with respect to the potential of the first electrode 2. Specifically, for example, a voltage of approximately 10 V is applied to the storage control line 22 so that the potential of the second electrode 3 can be higher than that of the first electrode 2.

In the configuration illustrated in Fig. 4, the signal detection circuit 40 includes an amplifier transistor 42, an address transistor 44, and a reset transistor 46. The amplifier transistor 42 is also referred to as a "charge detection transistor", and the address transistor 44 is also referred to as a "row select transistor". Typically, the amplifier transistor 42 and the address transistor 44 are each a field effect transistor (FET) formed on a semiconductor substrate. In the example described below, the transistors used are N-channel metal oxide semiconductor field effect transistors (MOSFETs) unless otherwise specified. The amplifier transistor 42, the address transistor 44, and the reset transistor 46 include a control terminal, an input terminal, and an output terminal. The control terminal is, for example, a gate. The input terminal is one of a drain and a source and, typically, is a drain. The output terminal is the other of the drain and the source and, typically, is the source.

Note that, in this specification, the "semiconductor substrate" is not limited to a substrate formed entirely of a semiconductor and may be, for instance, an insulating substrate including a semiconductor layer provided on a surface on the side on which the light-sensitive area is to be formed. An example of the semiconductor substrate is a p-type silicon substrate.

As illustrated in Fig. 4, one of the input terminal and the output terminal of the amplifier transistor 42 is connected to one of the input terminal and the output terminal of the address transistor 44. The control terminal of the amplifier transistor 42 is electrically connected to the first electrode 2 of the photoelectric converter 10C. The signal charges collected by the first electrode 2 are stored at a charge storage node 41, which is disposed between the first electrode 2 and the gate of the amplifier transistor 42. In the present embodiment, the signal charges are holes. The charge storage node 41 is an example of a charge storage and also referred to as a "floating diffusion node".

A voltage corresponding to the signal charges stored at the charge storage node 41 is applied to the gate of the amplifier transistor 42. The amplifier transistor 42 amplifies the voltage. That is, the amplifier transistor 42 amplifies a signal generated by the photoelectric converter 10C. The voltage amplified by the amplifier transistor 42 is selectively read as a signal voltage via the address transistor 44.

One of the source and the drain of the reset transistor 46 is connected to the charge storage node 41, and, therefore, the one of the source and the drain of the reset transistor 46 has an electrical connection with the first electrode 2.

The reset transistor 46 resets the signal charges stored at the charge storage node 41. In other words, the reset transistor 46 resets the potential of the gate of the amplifier transistor 42 and the potential of the first electrode 2.

As illustrated in Fig. 4, the imaging device 100 includes power lines 23, vertical signal lines 24, address signal lines 25, and reset signal lines 26. These lines are connected to the pixels 20. The power lines 23 are each connected to one of the source and the drain of the amplifier transistor 42 and provide a predetermined power supply voltage to the respective pixels 20. The power lines 23 serve as source follower power supplies. The vertical signal lines 24 are each connected to one of the source and the drain of the address transistor 44 that is not connected to the source or the drain of the amplifier transistor 42. The address signal lines 25 are each connected to the gate electrode of the address transistor 44. The reset signal lines 26 are each connected to the gate of the reset transistor 46.

The peripheral circuits of the imaging device 100 include a vertical scanning circuit 52, a horizontal signal readout circuit 54, a plurality of column signal processing circuits 56, a plurality of load circuits 58, and a plurality of inverting amplifiers 59. The vertical scanning circuit 52 is also referred to as a "row scanning circuit", the horizontal signal readout circuit 54 is also referred to as a "column scanning circuit", and the column signal processing circuit 56 is also referred to as a "row signal storage circuit". The column signal processing circuits 56, the load circuits 58, and the inverting amplifiers 59 are provided for the respective columns of the plurality of pixels 20, which are arranged in the row direction and the column direction. Each of the column signal processing circuits 56 is electrically connected to the pixels 20 arranged in a corresponding column, via the vertical signal line 24 provided for each of the columns of the plurality of pixels 20. The plurality of column signal processing circuits 56 are electrically connected to the horizontal signal readout circuit 54. Each of the load circuits 58 is electrically connected to a corresponding one of the vertical signal lines 24, and the load circuit 58 and the amplifier transistor 42 form a source follower circuit.

The vertical scanning circuit 52 is connected to the address signal lines 25 and the reset signal lines 26. The vertical scanning circuit 52 applies a row select signal, which is a signal for controlling the on and off of the address transistors 44, to the gates of the address transistors 44 via the address signal lines 25. The row select signal is sent on a per-address signal line 25 basis, and, accordingly, the row to be read is scanned and selected. A signal voltage is read out from the pixels 20 of the selected row to the vertical signal lines 24. Furthermore, the vertical scanning circuit 52 applies a reset signal, which is a signal for controlling the on and off of the reset transistors 46, to the gates of the reset transistors 46 via the reset signal lines 26. A row select signal is sent on a per-reset signal line 26 basis, and, accordingly, the row of the pixels 20 on which a reset operation is to be performed is selected. In this manner, the vertical scanning circuit 52 selects a plurality of pixels 20 on a row basis, to read a signal voltage and reset the potential of the first electrode 2.

The signal voltage read out from the pixel 20 selected by the vertical scanning circuit 52 is sent to the column signal processing circuit 56 via the vertical signal line 24. The column signal processing circuit 56 performs, for instance, noise suppression signal processing, representative examples of which include correlated double sampling, and analog-digital conversion (AD conversion). The horizontal signal readout circuit 54 sequentially reads out signals from the plurality of column signal processing circuits 56 to a horizontal common signal line (not illustrated).

Note that the vertical scanning circuit 52 may partially include the voltage supply circuit 30. Alternatively, the voltage supply circuit 30 may have an electrical connection with the vertical scanning circuit 52. In other words, the bias voltage may be applied to the second electrode 3 via the vertical scanning circuit 52.

In the configuration illustrated in Fig. 4, the plurality of inverting amplifiers 59 are provided for the respective columns. A negative-side input terminal of each of the inverting amplifiers 59 is connected to a corresponding one of the vertical signal lines 24. An output terminal of each of the inverting amplifiers 59 is connected to the pixels 20 of a corresponding column, via a feedback line 27, which is provided for each of the columns.

As illustrated in Fig. 4, the feedback line 27 is connected to one of the source and the drain (e.g. the drain) of the reset transistor 46 that is not connected to the charge storage node 41. Accordingly, in the inverting amplifier 59, the negative terminal receives an output from the address transistor 44 when a conductive state exists between the address transistor 44 and the reset transistor 46. The positive-side input terminal of the inverting amplifier 59 receives a reset reference voltage applied thereto from a power supply (not illustrated). The inverting amplifier 59 performs a feedback operation such that the gate voltage of the amplifier transistor 42 becomes equal to a predetermined feedback voltage. The "feedback voltage" is an output voltage of the inverting amplifier 59. The output voltage of the inverting amplifier 59 is, for example, 0 V or a positive voltage close to 0 V. The inverting amplifier 59 may be referred to as a "feedback amplifier".

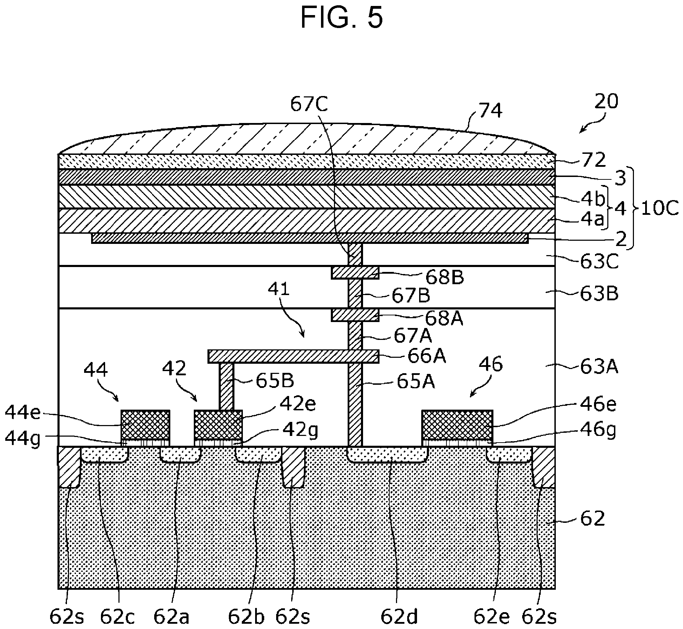

Fig. 5 is a schematic cross-sectional view of a device structure of the pixel 20 in the imaging device 100 according to the present embodiment. In the configuration illustrated in Fig. 5, the pixel 20 includes a semiconductor substrate 62, which supports the photoelectric converter 10C. The semiconductor substrate 62 is, for example, a silicon substrate. As illustrated in Fig. 5, the photoelectric converter 10C is disposed over the semiconductor substrate 62. In the imaging device 100, light enters the photoelectric converter 10C from above the photoelectric converter 10C. In this example, interlayer insulating layers 63A, 63B, and 63C are stacked on the semiconductor substrate 62, and the first electrode 2, the photoelectric conversion layer 4, and the second electrode 3 are disposed on the interlayer insulating layer 63C in the order stated. The first electrode 2 is made up of discrete portions that are provided for the respective pixels. Thus, the discrete portions of the first electrode 2 provided for any two adjacent pixels 20 are spatially separated from each other, and, therefore, any two adjacent discrete portions of the first electrode 2 are electrically separated from each other. The photoelectric conversion layer 4 and the second electrode 3 may be formed to extend over multiple pixels 20.

The amplifier transistor 42, the address transistor 44, and the reset transistor 46 are formed in or on the semiconductor substrate 62.

The amplifier transistor 42 includes impurity regions 62a and 62b, which are formed in the semiconductor substrate 62, a gate insulating layer 42g, which is located on the semiconductor substrate 62, and a gate electrode 42e, which is located on the gate insulating layer 42g. The impurity regions 62a and 62b serve as a drain or a source of the amplifier transistor 42. The impurity regions 62a and 62b and impurity regions 62c, 62d, and 62e, which will be described later, are, for example, n-type impurity regions.

The address transistor 44 includes impurity regions 62a and 62c, which are formed in the semiconductor substrate 62, a gate insulating layer 44g, which is located on the semiconductor substrate 62, and a gate electrode 44e, which is located on the gate insulating layer 44g. The impurity regions 62a and 62c serve as a drain or a source of the address transistor 44. In this example, the amplifier transistor 42 and the address transistor 44 share the impurity region 62a, and, accordingly, the source (or drain) of the amplifier transistor 42 is electrically connected to the drain (or source) of the address transistor 44.

The reset transistor 46 includes impurity regions 62d and 62e, which are formed in the semiconductor substrate 62, a gate insulating layer 46g, which is located on the semiconductor substrate 62, and a gate electrode 46e, which is located on the gate insulating layer 46g. The impurity regions 62d and 62e serve as a drain or a source of the reset transistor 46.

In the semiconductor substrate 62, an isolation region 62s is provided between adjacent pixels 20 and between the amplifier transistor 42 and the reset transistor 46. The isolation region 62s electrically separates adjacent pixels 20 from each other. Furthermore, the isolation region 62s provided between adjacent pixels 20 suppresses leakage of signal charges stored at the charge storage node 41.

A contact plug 65A, a contact plug 65B, and an interconnect 66A are formed in the interlayer insulating layer 63A. The contact plug 65A is connected to the impurity region 62d of the reset transistor 46, the contact plug 65B is connected to the gate electrode 42e of the amplifier transistor 42, and the interconnect 66A connects the contact plug 65A to the contact plug 65B. Accordingly, the impurity region 62d (e.g., drain) of the reset transistor 46 is electrically connected to the gate electrode 42e of the amplifier transistor 42. The configuration illustrated in Fig. 5 further includes a plug 67A and an interconnect 68A, which are formed in the interlayer insulating layer 63A. Furthermore, a plug 67B and an interconnect 68B are formed in the interlayer insulating layer 63B, and a plug 67C is formed in the interlayer insulating layer 63C. Accordingly, the interconnect 66A is electrically connected to the first electrode 2. The contact plug 65A, the contact plug 65B, the interconnect 66A, the plug 67A, the interconnect 68A, the plug 67B, the interconnect 68B, and the plug 67C are typically formed of a metal.

The configuration illustrated in Fig. 5 includes a protective layer 72, which is disposed on the second electrode 3. The protective layer 72 is not a substrate disposed to support the photoelectric converter 10C. The protective layer 72 is a layer for protecting and insulating the photoelectric converter 10C. The protective layer 72 may be highly transmissive to light at wavelengths that is absorbed by the photoelectric conversion layer 4. A material of the protective layer 72 may be any insulating material that is light-transmissive. For example, the material is SiON, AlO, or the like. As illustrated in Fig. 5, a microlens 74 may be disposed on the protective layer 72.

In the present embodiment, the photoelectric converter 10C is an example of a photoelectric conversion element and is formed of a photoelectric conversion element of the first embodiment. For example, as illustrated in Fig. 5, the photoelectric converter 10C has a structure similar to that of the photoelectric conversion element 10A described above. The second electrode 3 is disposed over the photoelectric conversion layer 4, that is, is disposed on a light-entering side of the imaging device 100 with respect to the photoelectric conversion layer 4. Light passes through the second electrode 3 before entering the photoelectric conversion layer 4. In the present embodiment, the second electrode 3 is, for example, a transparent electrode.

Note that the photoelectric converter 10C may have a structure similar to that of the photoelectric conversion element 10B described above and may have a structure in which one of the electron blocking layer 5 and the hole blocking layer 6 of the photoelectric conversion element 10B described above is not included. In this instance, too, the signal detection circuit 40 is connected to the first electrode 2, and the voltage supply circuit 30 provides a voltage to the second electrode 3 via the storage control line 22.

The imaging device 100, described above, can be manufactured with a typical semiconductor manufacturing process. In particular, in instances where a silicon substrate is used as the semiconductor substrate 62, the production can be carried out by using any of a variety of silicon semiconductor processes.

### [Modification]

A modification of the second embodiment will now be described. In the following description of the modification of the second embodiment, differences from the first embodiment and the second embodiment will be mainly described, and descriptions of common features will be omitted or simplified.

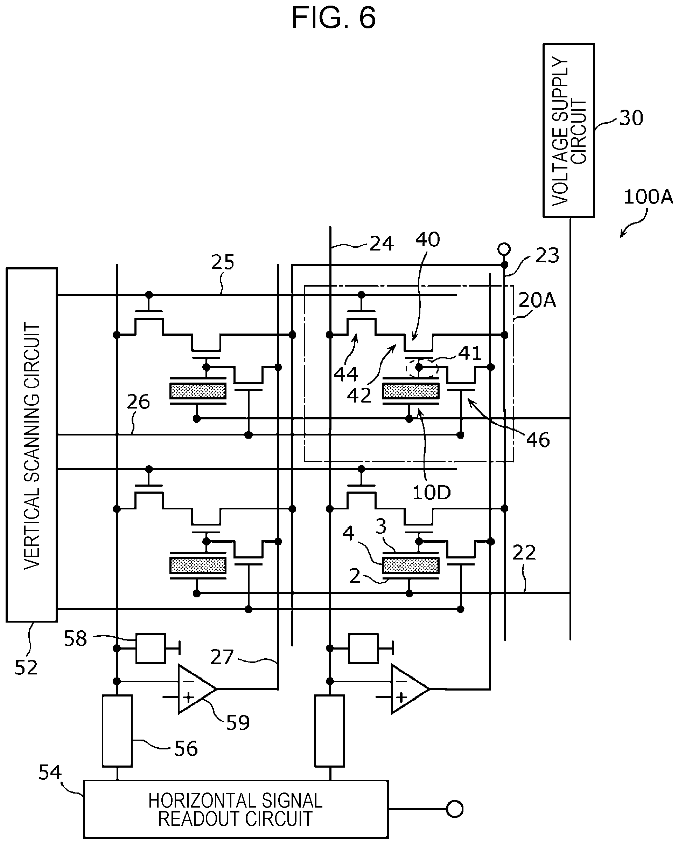

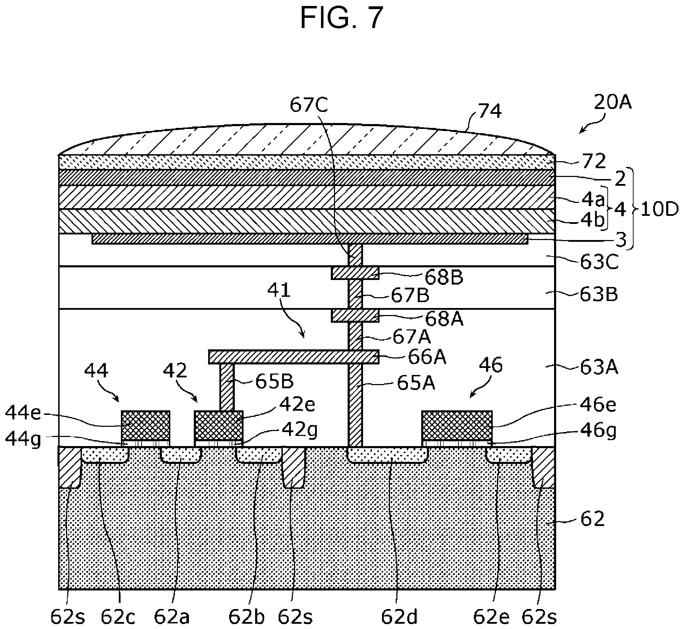

Fig. 6 is a diagram illustrating an exemplary circuit configuration of an imaging device 100A, according to the present modification. Fig. 7 is a schematic cross-sectional view of a device structure of a pixel 20A in the imaging device 100A according to the present modification.

As illustrated in Fig. 6 and Fig. 7, the imaging device 100A of the present modification is different from the imaging device 100 of the second embodiment in that the imaging device 100A is provided with a plurality of pixels 20A, each including a photoelectric converter 10D, rather than being provided with the plurality of pixels 20, each including the photoelectric converter 10C.

In the present modification, the plurality of pixels 20A each include a photoelectric converter 10D and a signal detection circuit 40, which detects a signal generated by the photoelectric converter 10D. Similar to the photoelectric converter 10C, the photoelectric converter 10D is formed of the photoelectric conversion element 10A or the photoelectric conversion element 10B of the first embodiment; however, the stacking order for the first electrode 2, the second electrode 3, and the photoelectric conversion layer 4 is opposite to that of the photoelectric converter 10C, as illustrated in Fig. 7. The second electrode 3 serves as a charge collector. The signal detection circuit 40 is connected to the second electrode 3. The first electrode 2 is connected to the voltage supply circuit 30 via a storage control line 22. In the operation of the imaging device 100A, a predetermined bias voltage is applied to the first electrode 2 via the storage control line 22. In the present modification, the second electrode 3 is a pixel electrode that collects signal charges, and the first electrode 2 is a counter electrode positioned opposite to the pixel electrode.

The photoelectric converter 10D has a configuration in which the electrons (i.e., negative charges) of the electron-hole pairs generated by photoelectric conversion are collected as signal charges by the second electrode 3. Controlling the potential of the first electrode 2 by using a bias voltage generated by the voltage supply circuit 30 enables the electrons to be collected by the second electrode 3. The voltage supply circuit 30 provides a voltage to the first electrode 2 via the storage control line 22. The voltage is a voltage in which the potential of the first electrode 2 is negative with respect to the potential of the second electrode 3.

As illustrated in Fig. 6, the control terminal of the amplifier transistor 42 is electrically connected to the second electrode 3 of the photoelectric converter 10D. The signal charges collected by the second electrode 3 are stored at the charge storage node 41, which is disposed between the second electrode 3 and the gate of the amplifier transistor 42. In the present modification, the signal charges are electrons.

In the pixel 20A, as illustrated in Fig. 7, the interlayer insulating layers 63A, 63B, and 63C are stacked on the semiconductor substrate 62, and the second electrode 3, the photoelectric conversion layer 4, and the first electrode 2 are disposed on the interlayer insulating layer 63C in the order stated. The second electrode 3 is made up of discrete portions that are provided for the respective pixels. Thus, the discrete portions of the second electrode 3 provided for any two adjacent pixels 20A are spatially separated from each other, and, therefore, any two adjacent discrete portions of the second electrode 3 are electrically separated from each other. The photoelectric conversion layer 4 and the first electrode 2 may be formed to extend over multiple pixels 20A.

In the present embodiment, the photoelectric converter 10D is an example of a photoelectric conversion element and is formed of a photoelectric conversion element of the first embodiment. For example, as illustrated in Fig. 7, the photoelectric converter 10D has a structure similar to that of the photoelectric conversion element 10A described above. The first electrode 2 is disposed over the photoelectric conversion layer 4, that is, is disposed on a light-entering side of the imaging device 100A with respect to the photoelectric conversion layer 4. Light passes through the first electrode 2 before entering the photoelectric conversion layer 4. In the present embodiment, the first electrode 2 is, for example, a transparent electrode.

Note that the photoelectric converter 10D may have a structure similar to that of the photoelectric conversion element 10B described above and may have a structure in which one of the electron blocking layer 5 and the hole blocking layer 6 of the photoelectric conversion element 10B described above is not included. In this instance, too, the signal detection circuit 40 is connected to the second electrode 3, and the voltage supply circuit 30 provides a voltage to the first electrode 2 via the storage control line 22.

### EXAMPLES

The present disclosure will now be described in detail with reference to Examples. It should be noted that the present disclosure is in no way limited to the Examples described below.

### (Example 1 and Comparative Examples 1 to 4)

First, Example 1 and Comparative Examples 1 to 4 will be described.

### [Preparation of Photoelectric Conversion Element]

Photoelectric conversion elements were prepared in the following manner.

### <Example 1>

A sheet of glass coated with ITO, which served as an electrode, was prepared to be used as a substrate. Before being used, the substrate was ultrasonically cleaned with acetone and propanol and subsequently dry-cleaned with a UV-ozone treatment. Subsequently, film forming for a photoelectric conversion element was performed in a glove box under a nitrogen atmosphere.

First, a poly-TPD chlorobenzene solution with a concentration of 6 mg/mL was spin-coated onto the ITO electrode to form an electron blocking layer with a thickness of 60 nm.

Subsequently, a PbS quantum dot octane solution with a concentration of 20 mg/mL was spin-coated onto the electron blocking layer. The PbS quantum dots had an absorption peak wavelength of 1400 nm. The solvent was then evaporated, subsequently, the resultant was immersed in a 1,4-BDT acetonitrile solution with a concentration of 1.5 mg/mL for 30 seconds to exchange surface-modifying ligands, and the resultant was washed twice with acetonitrile. The ligand exchange step was repeated five times. Accordingly, a first quantum dot layer with a thickness of 60 nm was formed. The first quantum dot layer had a surface modified with 1,4-BDT and was formed of PbS quantum dots having an absorption peak wavelength of 1400 nm.

Subsequently, a PbS quantum dot octane solution with a concentration of 20 mg/mL was spin-coated onto the first quantum dot layer. The PbS quantum dots had an absorption peak wavelength of 1200 nm. The solvent was then evaporated, subsequently, the resultant was immersed in a 0.06 vol.% mercaptopropionic acid (MPA)-doped zinc iodide (ZnI₂) ethanol solution with a concentration of 4.8 mg/mL for 5 seconds to exchange surface-modifying ligands, and the resultant was washed twice with ethanol. The ligand exchange step was repeated five times. Accordingly, a second quantum dot layer with a thickness of 60 nm was formed. The second quantum dot layer had a surface modified with ZnI₂:MPA and was formed of PbS quantum dots having an absorption peak wavelength of 1200 nm. In this manner, a photoelectric conversion layer having a structure including a stack of the first quantum dot layer and the second quantum dot layer was formed.

Subsequently, a zinc oxide nanoparticle dispersion (trade name: Avantama N-11) was spin-coated onto the second quantum dot layer to form a hole blocking layer with a thickness of 60 nm.

Lastly, a film of aluminum with a thickness of 80 nm was formed on the hole blocking layer by thermal vacuum deposition to form an aluminum electrode, and, accordingly, a photoelectric conversion element was obtained. Table 1 shows the absorption peak wavelengths and the surface-modifying ligands of the quantum dots used in the photoelectric conversion layer of the prepared photoelectric conversion element and also shows the thickness of the photoelectric conversion layer.

### <Comparative Example 1>

A photoelectric conversion element was prepared in a manner similar to that of Example 1, except that the PbS quantum dots used in the first quantum dot layer were used in the second quantum dot layer, and vice versa. Table 1 shows the absorption peak wavelengths and the surface-modifying ligands of the quantum dots used in the photoelectric conversion layer of the prepared photoelectric conversion element and also shows the thickness of the photoelectric conversion layer.

### <Comparative Example 2>

A photoelectric conversion element was prepared in a manner similar to that of Example 1, except that the ZnI₂:MPA used in the second quantum dot layer was replaced with 1,4-BDT. Table 1 shows the absorption peak wavelengths and the surface-modifying ligands of the quantum dots used in the photoelectric conversion layer of the prepared photoelectric conversion element and also shows the thickness of the photoelectric conversion layer.

### <Comparative Example 3>

A photoelectric conversion element was prepared in a manner similar to that of Comparative Example 2, except that the PbS quantum dots used in the first quantum dot layer were used in the second quantum dot layer, and vice versa. Table 1 shows the absorption peak wavelengths and the surface-modifying ligands of the quantum dots used in the photoelectric conversion layer of the prepared photoelectric conversion element and also shows the thickness of the photoelectric conversion layer.

### <Comparative Example 4>

An operation similar to that of Example 1 was performed, except for the formation of the photoelectric conversion layer. The photoelectric conversion layer was formed as follows. A PbS quantum dot mixture octane solution with a concentration of 20 mg/mL was spin-coated onto the electron blocking layer. The mixture contained PbS quantum dots having different particle diameters and respective absorption peak wavelengths of 1400 nm and 1200 nm, in a mass ratio of 1:1. The surface-modifying ligand of the PbS quantum dots was exchanged with 1,4-BDT in a manner similar to that of Example 1. Accordingly, a photoelectric conversion layer with a thickness of 120 nm was formed. The photoelectric conversion layer was formed of a mixture of PbS quantum dots having an absorption peak wavelength of 1200 nm and PbS quantum dots having an absorption peak wavelength of 1400 nm, each having a surface modified with 1,4-BDT. That is, in Comparative Example 4, the photoelectric conversion layer did not have the stack structure of the first quantum dot layer and the second quantum dot layer. Table 1 shows the absorption peak wavelengths and the surface-modifying ligand of the quantum dots used in the photoelectric conversion layer of the prepared photoelectric conversion element and also shows the thickness of the photoelectric conversion layer.

### [Evaluation of Photoelectric Conversion Element]

Evaluations of the photoelectric conversion elements prepared as described above were performed. Specifically, a dark current and external quantum efficiency were measured by introducing the photoelectric conversion elements into a sealable measurement jig in a glove box under a nitrogen atmosphere and using a long wavelengthsensitive spectral sensitivity measuring device (CEP-25RR, manufactured by Bunkoukeiki Co., Ltd.). Table 1 shows the values of the dark current resulting from the application of a voltage of -3 V to the ITO electrode.

In the measurement of the external quantum efficiency, the external quantum efficiency was measured under the condition in which a voltage of -3 V was applied to the ITO electrode. That is, the measurement of the external quantum efficiency was performed under conditions in which holes were collected by the ITO electrode, and the electrons were collected by the aluminum electrode. Table 1 shows the results of the measurement of the external quantum efficiency performed at a wavelength of 1200 nm and a wavelength of 1400 nm.

**[Table 1]**

| | Photoelectric conversion layer | | | Dark current (mA/cm²) | External quantum efficiency (%) | |
|---|---|---|---|---|---|---|
| | First quantum dot layer | Second quantum dot layer | Thickness (nm) | | | |
| | | | | | @ 1200 nm | @ 1400 nm |
| Example 1 | 1400 nm | 1200 nm | 120 | 3.4×10⁻⁴ | 4.0 | 10.6 |
| | 1,4-BDT | ZnI₂:MPA | | | | |
| Comparative Example 1 | 1200 nm | 1400 nm | 120 | 2.7×10⁻³ | 5.4 | 6.4 |
| | 1,4-BDT | ZnI₂:MPA | | | | |
| Comparative Example 2 | 1400 nm | 1200 nm | 120 | 2.2×10⁻³ | 5.0 | 8.7 |
| | 1,4-BDT | 1,4-BDT | | | | |
| Comparative Example 3 | 1200 nm | 1400 nm | 120 | 3.1×10⁻³ | 5.8 | 10.6 |
| | 1,4-BDT | 1,4-BDT | | | | |
| Comparative Example 4 | 1200 nm, 1400 nm | | 120 | 6.4×10⁻⁴ | 0.7 | 2.3 |
| | 1,4-BDT | | | | | |

In Table 1, in the columns labeled "First quantum dot layer" and "Second quantum dot layer", the upper row shows the absorption peak wavelengths of the quantum dots used in the respective layers, and the lower row shows the surface-modifying ligands used in the respective layers. The same applies to Tables 2 to 5, which will be described below.

As described above with reference to Fig. 3, ZnI₂:MPA is a surface-modifying ligand that increases the ionization potential of quantum dots to a greater extent than 1,4-BDT. As shown in Table 1, the photoelectric conversion element of Example 1 had a stack configuration including the first quantum dot layer and the second quantum dot layer that had different surface-modifying ligands, that is, had different ionization potentials, and the second quantum dot layer included quantum dots having a short absorption peak wavelength, that is, having a small particle size, with a surface of the quantum dots being modified with ZnI₂:MPA, which increases the ionization potential. With this configuration, the photoelectric conversion element of Example 1 had a high external quantum efficiency and a low dark current. In contrast, in Comparative Example 1, in which the quantum dots used in the first quantum dot layer and the quantum dots used in the second quantum dot layer had a particle size combination opposite to that of Example 1, the photoelectric conversion element had a higher dark current than the photoelectric conversion element of Example 1. In Comparative Example 1, the surface-modifying ligand was the same as that of Example 1, but the quantum dots used in the second quantum dot layer had a particle size larger than that of Example 1, and, consequently, the second quantum dot layer had a lower electron affinity than that of Example 1. As a result, in Comparative Example 1, presumably, the energy difference ΔE_{QD} at an interface between the first quantum dot layer and the second quantum dot layer was small, which increased a thermally excited dark current.

Furthermore, the photoelectric conversion elements of Comparative Example 2 and Comparative Example 3 also had a higher dark current than the photoelectric conversion element of Example 1. Although the zinc oxide layer with a thickness of 60 nm was provided as a hole blocking layer, there was a possibility that a conduction path that facilitated injection of holes into the second quantum dot layer from the aluminum electrode for collecting electrons existed. Such a case may have occurred due to a locally reduced thickness of the hole blocking layer or damage caused to the hole blocking layer during the deposition of the aluminum electrode for collecting electrons. In such an instance, a low ionization potential of the second quantum dot layer can be a factor for an increase in the dark current. In Comparative Example 2 and Comparative Example 3, the surface-modifying ligand used in the second quantum dot layer was 1,4-BDT, and, consequently, the ionization potentials of the second quantum dot layers were lower than those of Example 1 and Comparative Example 1. As a result, presumably, the injection of holes from the aluminum electrode was increased.

Furthermore, in Comparative Example 4, the photoelectric conversion layer was formed of a mixture of quantum dots having two particle sizes, and in this case, the external quantum efficiency was lower than those of the other examples. In the photoelectric conversion element of Comparative Example 4, although the dark current was low, the photoelectric conversion efficiency was also low, and thus, the sensitive wavelength was not extended. That is, presumably, the photoelectric conversion layer behaved like a large resistance, which hindered the current flow.

The results described above demonstrate that both an extended sensitive wavelength range and a reduced dark current can be achieved with high quantum efficiency in the instance in which, regarding the broadening of the sensitive wavelength by stacking the first quantum dot layer and the second quantum dot layer that include quantum dots having different respective particle sizes, the ionization potential is differentiated by using different surface-modifying ligands for the respective layers, and in addition, in the second quantum dot layer adjacent to the aluminum electrode for collecting electrons, the quantum dots having a relatively small particle size is modified with ZnI₂:MPA, which relatively increases the ionization potential.

### (Example 2 and Comparative Example 5)

Now, Example 2 and Comparative Example 5 will be described.

### [Preparation of Photoelectric Conversion Element]

Photoelectric conversion elements were prepared in the following manner.

### <Example 2>

A photoelectric conversion element was prepared in a manner similar to that of Example 1, except that the thicknesses of the first quantum dot layer and the second quantum dot layer were 180 nm. Table 2 shows the absorption peak wavelengths and the surface-modifying ligands of the quantum dots used in the photoelectric conversion layer of the prepared photoelectric conversion element and also shows the thickness of the photoelectric conversion layer.

### <Comparative Example 5>

A photoelectric conversion element was prepared in a manner similar to that of Comparative Example 4, except that the thickness of the photoelectric conversion layer was 360 nm. Table 2 shows the absorption peak wavelengths and the surface-modifying ligand of the quantum dots used in the photoelectric conversion layer of the prepared photoelectric conversion element and also shows the thickness of the photoelectric conversion layer.

### [Evaluation of Photoelectric Conversion Element]

Evaluations of the photoelectric conversion elements prepared as described above were performed by measuring the dark current and the external quantum efficiency in the manners previously described. Table 2 shows the values of the dark current and the results of the measurement of the external quantum efficiency performed at a wavelength of 1200 nm and a wavelength of 1400 nm.

**[Table 2]**

| | Photoelectric conversion layer | | | Dark current (mA/cm²) | External quantum efficiency (%) | |
|---|---|---|---|---|---|---|
| | First quantum dot layer | Second quantum dot layer | Thickness (nm) | | | |
| | | | | | @1200 nm | @1400 nm |
| Example 2 | 1400 nm | 1200 nm | 360 | 9.8×10⁻⁵ | 7.3 | 21.0 |
| | 1,4-BDT | ZnI₂:MPA | | | | |
| Comparative Example 5 | 1200 nm, 1400 nm | | 360 | 2.2×10⁻³ | 3.3 | 8.0 |
| | 1,4-BDT | | | | | |

As shown in Table 2, in the photoelectric conversion element of Example 2, the photoelectric conversion layer had a thickness larger than that of the photoelectric conversion element of Example 1, and, consequently, the external quantum efficiency was further improved, and the dark current was reduced. In contrast, in Comparative Example 5, in which the photoelectric conversion layer was formed of a mixture of quantum dots having two particle sizes, the photoelectric conversion element had a lower quantum efficiency and a higher dark current than the photoelectric conversion element of Example 2. In particular, regarding the reduction in the dark current, the larger the thickness of the photoelectric conversion layer, the greater the effect of the configuration of the present disclosure, and thus, the photoelectric conversion element of Example 2 realized a dark current lower than that of the photoelectric conversion element of Comparative Example 5 by two orders of magnitude.

### (Example 3 and Comparative Examples 6 and 7)

Now, Example 3 and Comparative Examples 6 and 7 will be described.

### [Preparation of Photoelectric Conversion Element]

Photoelectric conversion elements were prepared in the following manner.

### <Example 3>

A photoelectric conversion element was prepared in a manner similar to that of Example 2, except that the first quantum dot layer was formed with PbS quantum dots having an absorption peak wavelength of 1450 nm, and the second quantum dot layer was formed with PbS quantum dots having an absorption peak wavelength of 1300 nm. Table 3 shows the absorption peak wavelengths and the surface-modifying ligands of the quantum dots used in the photoelectric conversion layer of the prepared photoelectric conversion element and also shows the thickness of the photoelectric conversion layer.

### <Comparative Example 6>

A photoelectric conversion element was prepared in a manner similar to that of Example 3, except that the PbS quantum dots used in the first quantum dot layer were used in the second quantum dot layer, and vice versa. Table 3 shows the absorption peak wavelengths and the surface-modifying ligands of the quantum dots used in the photoelectric conversion layer of the prepared photoelectric conversion element and also shows the thickness of the photoelectric conversion layer.

### <Comparative Example 7>

A photoelectric conversion element was prepared in a manner similar to that of Comparative Example 5, except that the photoelectric conversion layer was formed with a PbS quantum dot mixture octane solution with a concentration of 20 mg/mL, where the mixture contained PbS quantum dots having different particle diameters and respective absorption peak wavelengths of 1450 nm and 1300 nm, in a mass ratio of 1:1. Table 3 shows the absorption peak wavelengths and the surface-modifying ligand of the quantum dots used in the photoelectric conversion layer of the prepared photoelectric conversion element and also shows the thickness of the photoelectric conversion layer.

### [Evaluation of Photoelectric Conversion Element]

Evaluations of the photoelectric conversion elements prepared as described above were performed by measuring the dark current and the external quantum efficiency in the manners previously described. Table 3 shows the values of the dark current and the results of the measurement of the external quantum efficiency performed at a wavelength of 1300 nm and a wavelength of 1480 nm.

**[Table 3]**

| | Photoelectric conversion layer | | | Dark current (mA/cm²) | External quantum efficiency (%) | |
|---|---|---|---|---|---|---|
| | First quantum dot layer | Second quantum dot layer | Thickness (nm) | | | |
| | | | | | @1300 nm | @1480 nm |
| Example 3 | 1450 nm | 1300 nm | 360 | 5.0×10⁻⁴ | 8.5 | 34.0 |
| | 1,4-BDT | ZnI₂:MPA | | | | |
| Comparative Example 6 | 1300 nm | 1450 nm | 360 | 1.2×10⁻² | 15.4 | 17.1 |
| | 1,4-BDT | ZnI₂:MPA | | | | |
| Comparative Example 7 | 1300 nm, 1450 nm | | 360 | 1.6×10⁻³ | 2.9 | 7.8 |
| | 1,4-BDT | | | | | |

As shown in Table 3, it was demonstrated that the photoelectric conversion element of Example 3, in which quantum dots having particle sizes different from those of the photoelectric conversion elements of Example 1 and Example 2 were used, also had a high external quantum efficiency and a low dark current. In contrast, the photoelectric conversion element of Comparative Example 6, in which the quantum dots used in the first quantum dot layer and the quantum dots used in the second quantum dot layer had a particle size combination opposite to that of Example 3, had a higher dark current than the photoelectric conversion element of Example 3. Furthermore, the photoelectric conversion element of Comparative Example 7, in which the photoelectric conversion layer was formed of a mixture of quantum dots having two particle sizes, had a lower quantum efficiency and a higher dark current than the photoelectric conversion element of Example 3.

### (Example 4 and Comparative Example 8)

Now, Example 4 and Comparative Example 8 will be described.

### [Preparation of Photoelectric Conversion Element]

Photoelectric conversion elements were prepared in the following manner.

### <Example 4>

A photoelectric conversion element was formed in a manner similar to that of Example 2, except that the first quantum dot layer was formed with a PbS quantum dot mixture octane solution with a concentration of 20 mg/mL, where the mixture contained PbS quantum dots having different particle diameters and respective absorption peak wavelengths of 1300 nm and 1450 nm, in a mass ratio of 1:1; and the second quantum dot layer was formed with a PbS quantum dot mixture octane solution with a concentration of 20 mg/mL, where the mixture contained PbS quantum dots having different particle diameters and respective absorption peak wavelengths of 1000 nm and 1200 nm, in a mass ratio of 1:1. Table 4 shows the absorption peak wavelengths and the surface-modifying ligands of the quantum dots used in the photoelectric conversion layer of the prepared photoelectric conversion element and also shows the thickness of the photoelectric conversion layer.

### <Comparative Example 8>

A photoelectric conversion element was prepared in a manner similar to that of Comparative Example 5, except that a PbS quantum dot mixture octane solution with a concentration of 20 mg/mL was used, where the mixture contained PbS quantum dots having different particle diameters and respective absorption peak wavelengths of 1000 nm, 1200 nm, 1300 nm, and 1450 nm, in a mass ratio of 1:1:1:1. Table 4 shows the absorption peak wavelengths and the surface-modifying ligand of the quantum dots used in the photoelectric conversion layer of the prepared photoelectric conversion element and also shows the thickness of the photoelectric conversion layer.

### [Evaluation of Photoelectric Conversion Element]

Evaluations of the photoelectric conversion elements prepared as described above were performed by measuring the dark current and the external quantum efficiency in the manners previously described. Table 4 shows the values of the dark current and the results of the measurement of the external quantum efficiency performed at wavelengths of 1000 nm, 1200 nm, 1360 nm, and 1440 nm.

**[Table 4]**

| | Photoelectric conversion layer | | | Dark current (mA/cm²) | External quantum efficiency (%) | | | |
|---|---|---|---|---|---|---|---|---|
| | First quantum dot layer | Second quantum dot layer | Thickness (nm) | | | | | |
| | | | | | @1000 nm | @1200 nm | @1360 nm | @1440 nm |
| Example 4 | 1300 nm, 1450 nm | 1000 nm, 1200 nm | 360 | 8.7×10⁻³ | 14.8 | 2.0 | 14.7 | 16.8 |
| | 1,4-BDT | ZnI₂:MPA | | | | | | |
| Comparative Example 8 | 1000 nm, 1200 nm, 1300 nm, 1450 nm | | 360 | 1.6×10⁻² | 2.2 | 0.9 | 0.4 | 0.8 |
| | 1,4-BDT | | | | | | | |

As shown in Table 4, the photoelectric conversion element of Example 4 had a higher quantum efficiency and a lower dark current than the photoelectric conversion element of Comparative Example 8. That is, with the effect of the configuration of the present disclosure, both an extended sensitive wavelength range and a reduced dark current can be achieved with high quantum efficiency even in the instance in which multiple sets of quantum dots with different respective particle sizes are used both in the first quantum dot layer and in the second quantum dot layer, as long as the ionization potential is differentiated by using different surface-modifying ligands for the respective layers, and in addition, in the second quantum dot layer adjacent to the aluminum electrode for collecting electrons, a surface of the quantum dots having a relatively large particle diameter is modified with ZnI₂:MPA, which relatively increases the ionization potential. In Example 4, multiple sets of quantum dots with different respective particle sizes were used both in the first quantum dot layer and in the second quantum dot layer, and, therefore, the particle diameter distribution of the quantum dots of each of the layers, namely, the first quantum dot layer and the second quantum dot layer, had at least two different local maximum values.

### (Example 5 and Comparative Example 9)

Now, Example 5 and Comparative Example 9 will be described.

### [Preparation of Photoelectric Conversion Element]

Photoelectric conversion elements were prepared in the following manner.

### <Example 5>

A photoelectric conversion element was formed in a manner similar to that of Example 4, except that the hole blocking layer was formed by depositing fullerene (C₆₀) to a thickness of 50 nm by vacuum vapor deposition, instead of forming a film of zinc oxide, and that an ITO electrode was formed, instead of an aluminum electrode, on the hole blocking layer by depositing a film of ITO by sputtering to a thickness of 30 nm. Table 5 shows the absorption peak wavelengths and the surface-modifying ligands of the quantum dots used in the photoelectric conversion layer of the prepared photoelectric conversion element and also shows the thickness of the photoelectric conversion layer.

### <Comparative Example 9>

A photoelectric conversion element was formed in a manner similar to that of Comparative Example 8, except that the hole blocking layer was formed by depositing fullerene (C₆₀) to a thickness of 50 nm by vacuum vapor deposition, instead of forming a film of zinc oxide, and that an ITO electrode was formed, instead of an aluminum electrode, on the hole blocking layer by depositing a film of ITO by sputtering to a thickness of 30 nm. Table 5 shows the absorption peak wavelengths and the surface-modifying ligand of the quantum dots used in the photoelectric conversion layer of the prepared photoelectric conversion element and also shows the thickness of the photoelectric conversion layer.

### [Evaluation of Photoelectric Conversion Element]

Evaluations of the photoelectric conversion elements prepared as described above were performed by measuring the dark current and the external quantum efficiency in the manners previously described. Note that the dark current and the external quantum efficiency were measured under the condition in which a voltage of -5 V was applied to the ITO electrode on the substrate-side. Furthermore, the measurement of the external quantum efficiency was performed by causing light to enter from the side of the ITO electrode formed by sputtering, which was the side opposite to the ITO substrate-side. Table 5 shows the values of the dark current and the results of the measurement of the external quantum efficiency performed at wavelengths of 1000 nm, 1180 nm, 1340 nm, and 1480 nm.

**[Table 5]**

| | Photoelectric conversion layer | | | Dark current (mA/cm²) | External quantum efficiency (%) | | | |
|---|---|---|---|---|---|---|---|---|
| | First quantum dot layer | Second quantum dot layer | Thickness (nm) | | | | | |
| | | | | | @1000 nm | @1180 nm | @1340 nm | @1480 nm |
| Example 5 | 1300 nm, 1450 nm | 1000 nm, 1200 nm | 360 | 1.1×10⁻⁴ | 19.2 | 13.6 | 7.4 | 6.7 |
| | 1,4-BDT | ZnI₂:MPA | | | | | | |
| Comparative Example 9 | 1000 nm, 1200 nm, 1300 nm, 1450 nm | | 360 | 1.4×10⁻⁴ | 3.2 | 1.4 | 1.3 | 1.5 |
| | 1,4-BDT | | | | | | | |

As shown in Table 5, the photoelectric conversion element of Example 5 had a higher quantum efficiency and a lower dark current than the photoelectric conversion element of Comparative Example 9. That is, the effect of the configuration of the present disclosure was successfully produced even with the change in the material of the hole blocking layer from that of Example 4. Furthermore, the effect of the configuration of the present disclosure was successfully produced even in the instance in which light entered from the direction opposite to that of Example 4. Accordingly, both an extended sensitive wavelength range and a reduced dark current can be achieved with high quantum efficiency, regardless of the direction of the entering light, as long as the ionization potential is differentiated by using different surface-modifying ligands for the respective layers, and in addition, in the second quantum dot layer adjacent to the electrode for collecting electrons, a surface of the quantum dots having a relatively large particle diameter is modified with ZnI₂:MPA, which relatively increases the ionization potential.

In the embodiments described above, the energy gap of the second quantum dot layer 4b is greater than the energy gap of the first quantum dot layer 4a because of the fact that the particle diameter of the second quantum dots included in the second quantum dot layer 4b is smaller than the particle diameter of the first quantum dots included in the first quantum dot layer 4a. However, the energy gap (i.e., absorption peak wavelength) of a quantum dot layer can be controlled with the constituent elements of the quantum dots that are to be included.

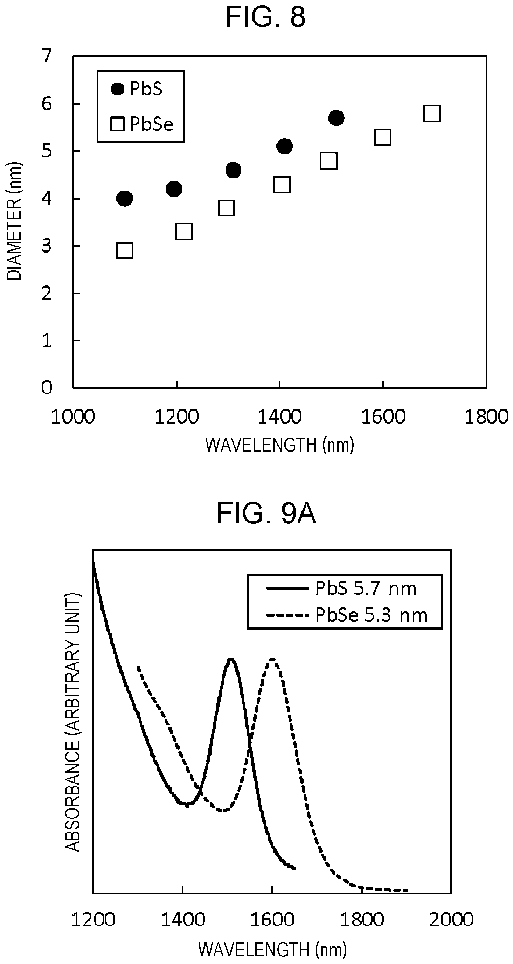

Fig. 8 illustrates a relationship between a maximum absorption peak wavelength and a diameter, regarding PbS quantum dots and PbSe quantum dots manufactured by NNCrystal. As illustrated in Fig. 8, in the instance where the elements that constitute the quantum dots are the same, there is a positive correlation between the absorption peak wavelength and the particle size, that is, the smaller the particle size, the shorter the absorption peak wavelength. On the other hand, it can be seen that the quantum dots having different constituent elements have different absorption peak wavelengths even if their particle sizes are the same. Accordingly, by using quantum dots having different constituent elements, a stack structure including quantum dot layers having the same particle size but having different absorption peak wavelengths can be realized. Furthermore, even if a stacking order associated with the particle sizes that is different from the stacking order of Examples 1 to 5 is employed, a similar relationship regarding the absorption peak wavelength can be realized.

An example of a photoelectric conversion element in which quantum dots having different constituent elements are used will be described with reference to Figs. 9A to 9C. Fig. 9A is a graph illustrating an absorption spectrum of PbS quantum dots having a diameter of 5.7 nm and an absorption spectrum of PbSe quantum dots having a diameter of 5.3 nm. The graph demonstrates that the PbS quantum dots, which have a larger particle diameter, have a shorter absorption peak wavelength (i.e., a larger energy gap).

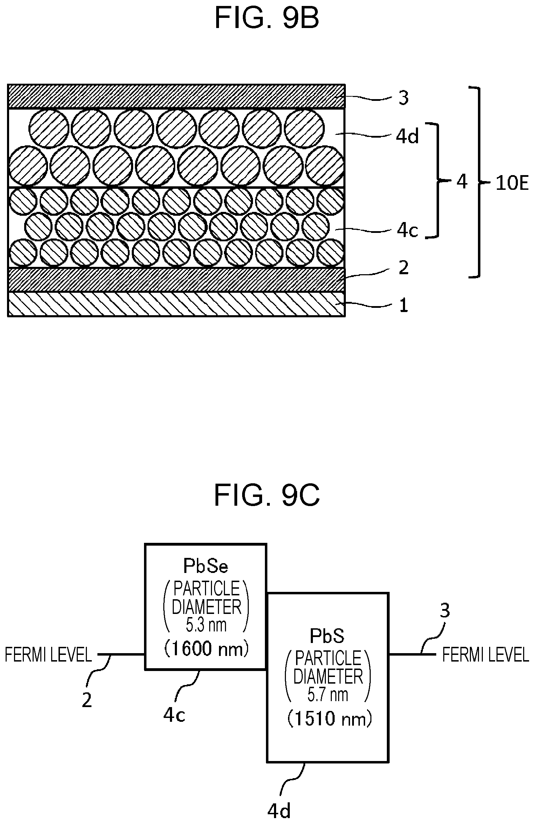

Fig. 9B is a schematic cross-sectional view of a configuration of a photoelectric conversion element 10E, which employs the combination of the quantum dots that are illustrated in Fig. 9A. In the photoelectric conversion element 10E, a first quantum dot layer 4c, which includes the PbSe quantum dots, is positioned near the first electrode 2 that collects holes, and the second quantum dot layer 4d, which includes the PbS quantum dots that have a larger particle diameter and a larger energy gap than the PbSe quantum dots, is positioned near the second electrode 3 that collects electrons.

Fig. 9C is an illustration of an energy diagram of the photoelectric conversion element 10E. The second quantum dot layer 4d has a shorter absorption peak wavelength and a larger energy gap than the first quantum dot layer 4c. Furthermore, for each of the quantum dot layers, the ligand that modifies a surface of the quantum dots is selected such that the ionization potential of the second quantum dot layer 4d can be relatively high. With this configuration, both an extended sensitive wavelength range and a reduced dark current can be achieved with high quantum efficiency, as with the photoelectric conversion elements presented in Examples 1 to 5.

While photoelectric conversion elements and imaging devices of the present disclosure have been described above with reference to embodiments, a modification, and examples, it should be noted that the present disclosure is not limited to the embodiments, the modification, and the examples. Any of various modifications contemplated by those skilled in the art may be applied to the embodiments, the modification, and the examples, and some of the constituent elements in the embodiments, the modification, and the examples may be combined to constitute different embodiments. These modifications are also encompassed by the scope of the present disclosure as long as they do not depart from the essence of the present disclosure.

For example, a photoelectric conversion element of the present disclosure can allow the charge generated by light to be extracted as energy and, therefore, may be used as a solar cell. Furthermore, a photoelectric conversion element of the present disclosure can allow the charge generated by light to be extracted as a signal and, therefore, may be used as an optical sensor.

### Industrial Applicability

Photoelectric conversion elements and imaging devices of the present disclosure can be used in photodiodes, image sensors, and the like and, in particular, can be used in high-sensitivity, low-dark-current optical sensing that utilizes infrared wavelengths.

### Reference Signs List

1 substrate
2 first electrode
3 second electrode
4 photoelectric conversion layer
4a, 4c first quantum dot layer
4b, 4d second quantum dot layer
5 electron blocking layer
6 hole blocking layer
10A, 10B, 10E photoelectric conversion element
10C, 10D photoelectric converter
20, 20A pixel
22 storage control line
23 power line
24 vertical signal line
25 address signal line
26 reset signal line
27 feedback line
30 voltage supply circuit
40 signal detection circuit
41 charge storage node
42 amplifier transistor
42e, 44e, 46e gate electrode
42g, 44g, 46g gate insulating layer
44 address transistor
46 reset transistor
52 vertical scanning circuit
54 horizontal signal readout circuit
56 column signal processing circuit
58 load circuit
59 inverting amplifier
62 semiconductor substrate
62a, 62b, 62c, 62d, 62e impurity region
62s isolation region
63A, 63B, 63C interlayer insulating layer
65A, 65B contact plug
66A interconnect
67A, 67B, 67C plug
68A, 68B interconnect
72 protective layer
74 microlens
100, 100A imaging device

## Claims

1. A photoelectric conversion element comprising:
a photoelectric conversion layer;
a first electrode that collects holes generated in the photoelectric conversion layer; and
a second electrode that is positioned opposite to the first electrode with the photoelectric conversion layer being disposed between the second electrode and the first electrode and that collects electrons generated in the photoelectric conversion layer,
wherein
the photoelectric conversion layer includes
a first quantum dot layer including a plurality of first quantum dots having a surface modified with a first ligand, and
a second quantum dot layer located between the first quantum dot layer and the second electrode and including a plurality of second quantum dots having a surface modified with a second ligand that is different from the first ligand,
the second quantum dot layer has an ionization potential greater than an ionization potential of the first quantum dot layer, and
a second value that represents a particle diameter distribution of the plurality of second quantum dots is less than a first value that represents a particle diameter distribution of the plurality of first quantum dots.

2. The photoelectric conversion element according to claim 1, wherein the plurality of first quantum dots and the plurality of second quantum dots each independently include at least one of CdSe, CdS, PbS, PbSe, PbTe, ZnO, ZnS, Cu₂ZnSnS₄, Cu₂S, CuInSe₂, AgInS₂, AgInTe₂, CdSnAs₂, ZnSnAs₂, ZnSnSb₂, Bi₂S₃, Ag₂S, Ag₂Te, HgTe, CdHgTe, Ge, GeSn, InAs, and InSb.

3. The photoelectric conversion element according to claim 1 or 2, wherein
the first ligand has a first dipole moment,
the second ligand has a second dipole moment, and
the first dipole moment is greater than the second dipole moment provided that the first dipole moment is positive when the first dipole moment points outside of each of the plurality of first quantum dots, and that the second dipole moment is positive when the second dipole moment points outside of each of the plurality of second quantum dots.

4. The photoelectric conversion element according to any one of claims 1 to 3, wherein
the first ligand is 1,4-benzenedithiol, and
the second ligand is a mixture of ZnI₂ and 3-mercaptopropionic acid.

5. The photoelectric conversion element according to any one of claims 1 to 4, wherein at least one of the particle diameter distribution of the plurality of first quantum dots and the particle diameter distribution of the plurality of second quantum dots has at least two different local maximum values.

6. An imaging device comprising:
a plurality of pixels, the plurality of pixels each including the photoelectric conversion element according to any one of claims 1 to 5.

7. The imaging device according to claim 6, further comprising:
a signal readout circuit connected to the first electrode; and
a voltage supply circuit that provides a voltage to the second electrode, the voltage being a voltage in which a potential of the second electrode is positive with respect to a potential of the first electrode.

8. The imaging device according to claim 6, further comprising:
a signal readout circuit connected to the second electrode; and
a voltage supply circuit that provides a voltage to the first electrode, the voltage being a voltage in which a potential of the first electrode is negative with respect to a potential of the second electrode.

9. A photoelectric conversion element comprising:
a photoelectric conversion layer;
a first electrode that collects holes generated in the photoelectric conversion layer; and
a second electrode that is positioned opposite to the first electrode with the photoelectric conversion layer being disposed between the second electrode and the first electrode and that collects electrons generated in the photoelectric conversion layer,
wherein
the photoelectric conversion layer includes
a first quantum dot layer including a plurality of first quantum dots having a surface modified with a first ligand, and
a second quantum dot layer located between the first quantum dot layer and the second electrode and including a plurality of second quantum dots having a surface modified with a second ligand that is different from the first ligand,
the second quantum dot layer has an ionization potential greater than an ionization potential of the first quantum dot layer,
an absorption peak wavelength of the plurality of second quantum dots is shorter than an absorption peak wavelength of the plurality of first quantum dots, and
a material of the first quantum dots is different from a material of the second quantum dots.

10. The photoelectric conversion element according to claim 9, wherein a second value that represents a particle diameter distribution of the plurality of first quantum dots is equal to a first value that represents a particle diameter distribution of the plurality of second quantum dots.

11. The photoelectric conversion element according to claim 9, wherein a second value that represents a particle diameter distribution of the plurality of second quantum dots is greater than a first value that represents a particle diameter distribution of the plurality of first quantum dots.
